# EUROPEAN PATENT SPECIFICATION

(11) **EP 2 365 604 B1**
(45) Date of publication and mention of the grant of the patent: **10.10.2018**
(21) Application number: 11156397.9
(22) Date of filing: 01.03.2011
(51) Int. Cl.: H02J 7/00, H01L 35/28, H01L 35/34, H01M 10/44, H02J 1/10, H01L 35/00, H01M 10/46, H02J 7/34, H04N 1/00, H01M 10/0525, H01M 10/48, H01M 16/00, H01L 35/30

(54) **Rechargeable power supply system arranged between external power supply and load**
Wiederaufladbares Stromversorgungssystem zwischen einer externen Stromversorgung und einer Last
Système d'alimentation électrique rechargeable agencé entre une alimentation électrique externe et une charge

(30) Priority: 08.03.2010 JP 2010050723
(43) Date of publication of application: 14.09.2011
(73) Proprietor: Konica Minolta Business Technologies, Inc., Chiyoda-ku Tokyo 100-0005 (JP)
(72) Inventor: Hasebe, Takashi, Tokyo 100-0005 (JP); Hiraguchi, Hiroshi, Tokyo 100-0005 (JP); Yamamoto, Mineo, Tokyo 100-0005 (JP)
(74) Representative: Hoffmann Eitle

(56) References cited:
- JP-A- 2004 063 384
- US-A1- 2009 151 765
- US-A1- 2009 260 668
- US-A1- 2009 283 124

## Description

### BACKGROUND OF THE INVENTION

### Field of the Invention

The present intention relates to a rechargeable power supply system arranged between an external power supply and a load, and particularly to a structure that can collect or recover, as electric energy, heat that occurs during charging and discharging.

### Description of the Related Art

In recent years, various kinds of rechargeable devices have undergone technological innovation. Such chargeable devices are applied to various devices primarily for the purpose of reduction of electric power consumption and improvement of energy efficiency.

Such rechargeable devices utilize electrochemical reactions to store or discharge electric energy. During the charging and discharging, a thermal reaction (i.e:, heat generation or absorption) occurs. A technology for collecting the thermal energy generated by such thermal reactions as electric energy for further improving efficiency of use of electric power has been proposed.

For example, Japanese Laid-Open Patent Publication No. 2004-063384 has disclosed a battery-containing power supply device that converts heat generated from a battery capable of charging and discharging into an electric power, and uses it so that the device uses effectively the electric power by reducing the electric energy that is wastefully abandoned as heat.

The battery-containing power supply device disclosed in the above Japanese Laid-Open Patent Publication No. 2004-063384 is primarily aimed at a battery such as a nickel-hydrogen battery or a nickel-cadmium battery of which substantially available capacity will reduce due to memory effect as shallow charging and discharging are repeated. Thus, this power supply device is merely aimed at effective use of the thermal energy that occurs during refresh discharging for the purpose of eliminating reduction in capacity.

However, even in an ordinary form of use (charge/discharge cycle), a thermal reaction also occurs, and therefore the efficiency of use of the electric power can be further improved by collecting the thermal energy that occurs as described above. JP 2004/063384 discloses a circuit with a number of cells and a number of power generating units realised by thermoelectric elements which are either fixed to the respective cell (or capacitor) or even to the power connecting lines or the circuits. All the heat generating elements, i.e. cells, the lines and the circuits are separately arranged and the cells do not perform "inverse" different heat absorbing and heat generating actions during charging and discharging. They simply generate heat which is picked up separately by the respective thermoelectric element.

### SUMMARY OF THE INVENTION

The invention has been made for overcoming the above problems, and an object of the invention is to provide a power supply system that collects thermal energy even during ordinary charge/discharge operations, and thereby can improve the efficiency of use of the power (i.e., electric power).

According to an aspect of the invention, a power supply system arranged between an external power supply and a load is provided. The power supply system includes a power storage module including (i) first and second power storage units arranged with a predetermined space therebetween and (ii) a power generating unit being capable of contacting with both the first and second power storage units concurrently, and formed of a thermoelectric converting element; and a control unit for controlling charging and discharging of the first and second power storage units. In the first and second power storage units, different thermal reactions occur depending on whether a charging operation or a discharging operation is performed. The thermal reactions are a heat absorbing reaction and a heat generating reaction. The control unit renders one of the first and second power storage units dischargeable and renders the other power storage unit chargeable.

Preferably, the power supply system further includes a switching mechanism for the power storage module between a first contact state in which first and second portions of the power storage unit are in contact with the first and second power storage units, respectively, and a second state in which the second and first portions of the power generating unit are in contact with the first and second power storage units, respectively.

Further preferably, the control unit is configured to switch, according to a predetermined condition, a state between a first charge/discharge state rendering the first power storage unit dischargeable and rendering the second power storage unit chargeable, and a second charge/discharge state rendering the first power storage unit chargeable and rendering the second power storage unit dischargeable. The switching mechanism performs the switching between the first and second contact states in response to the switching between the first and second charge/discharge states by the control unit.

Alternatively and preferably, the power supply system further includes a pair of the power storage modules including first and second power storage modules; and a switching mechanism for performing switching between first and second contact states with regard to a first power generating unit being the power generating unit included in the first power storage module and a second power generating unit being the power generating unit included in the second power storage module, In the first contact state, the first power generating unit has, in the first power storage module, a first portion being in contact with the first power storage unit and a second portion being in contact with the second power storage unit, and the second power generating unit has, in the second power storage module, a first portion being in contact with the first power storage unit and a second portion being in contact with the second power storage unit. In the second contact state, the first power generating unit has, in the second power storage module, a first portion being in contact with the second power storage unit and a second portion being in contact with the first power storage unit. The second power generating unit has, in the first power storage module, a first portion being in contact with the second power storage unit and a second portion being in contact with the first power storage unit.

Further preferably, the first and second power storage modules are spaced in a first direction from each other by the predetermined distance. The first and second power storage units in the first power storage module are aligned in a second direction perpendicular to the first direction. The first and second power storage units in the second power storage module are aligned in the second direction and are arranged in an order opposite to an arrangement order in the first power storage module, The switching mechanism moves the first power storage unit in the first direction, and moves the second power generating unit in the first direction and oppositely to the movement of the first power generating unit.

Preferably, the power storage module further includes a pressing mechanism for enhancing a degree of intimate contact between the first power storage unit and the power generating unit as well as a degree of intimate contact between the second power storage unit and the power generating unit.

Further preferably, the pressing mechanism releases a pressure applied to the first and second power storage units and the power generating unit when the switching mechanism switches the state between the first and second contact states.

Alternatively and further preferably, the first and second portions of the power generating unit are a pair of opposite surfaces of the power generating unit, respectively, and the first and second power storage units are aligned to each other in a direction perpendicular to the pair of surfaces to locate the power generating unit between the power storage units. The pressing mechanism applies the pressure toward at least one of the paired surfaces.

Further preferably, each of the paired surfaces serving as the first and second portions of the power generating unit, respectively, has an area equal to or smaller than an area of the first or second power storage unit in contact with the surface.

Alternatively and preferably, the power storage module includes the plurality of first power storage units, the plurality of second power storage units and the plurality of power generating units. The first and second power storage units are arranged alternately to each other in a predetermined direction. Each of the power generating units is arranged between the first and second power storage units neighboring to each other.

Preferably, the control unit charges one of the first and second power storage units, using a power generated by the power generating unit.

Preferably, the control unit includes an auxiliary power storage unit for driving the control unit, and the control unit charges the auxiliary power storage unit, using the power generated by the power generating unit.

Further preferably, the auxiliary power storage unit includes a cell formed of at least one of an electric double layer capacitor, a lithium ion battery and a lithium ion capacitor.

Preferably, the first and second power storage units include a cell formed of one of a lithium ion capacitor and a lithium ion polymer.

Preferably, the thermoelectric converting element is a bismuth-tellurium-containing element.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a view showing a schematic structure of an image forming apparatus according to an embodiment of the invention.
Fig, 2 is a functional block diagram showing a power supply system and a main control unit according to the embodiment of the invention.
Fig. 3 is a view for showing an operation principle of a thermoelectric converting device forming a power generating unit according to the embodiment of the invention.
Fig. 4 is a cross section schematically showing a structure of the power generating unit according to the embodiment of the invention.
Figs. 5 to 11 are schematic views for illustrating structures and operations of a power storage module according to the embodiment of the invention, respectively.
Figs. 12A - 12C show an example of a switching mechanism in the power supply system according to the embodiment of the invention.
Fig. 13 shows a circuit structure relating to charging and discharging according to the embodiment of the invention.
Fig. 14 is a time chart showing an example of an operation according to an application example 1 of the embodiment of the invention.
Fig. 15 is a flowchart showing a processing procedure according to the application example 1 of the embodiment of the invention.
Fig. 16 is a time chart showing an example of an operation according to an application example 2 of the embodiment of the invention.
Fig. 17 is a flowchart showing a processing procedure according to the application example 2 of the embodiment of the invention.
Fig. 18 is a functional block diagram showing a power supply system and a main control unit according to a modification of the embodiment of the invention.
Figs. 19 to 23 are schematic views for illustrating structures and operations of a power storage module according to the modification of the embodiment, respectively.
Figs. 24A and 24B show an example of a switching mechanism in the power supply system according to the modification of the embodiment of the invention.

### DESCRIPTION OF THE PREFERRED EMBODIMENTS

Embodiments of the invention will now be described with reference to the drawings. In the following description, the same or corresponding portions bear the same reference numbers, and description thereof is not repeated.

A power supply system according to an embodiment of the invention is arranged between an external power supply and a load, can store a part or whole of a power (i.e., electric power) supplied from the external power supply in a power storage unit and, when necessary, can supply the stored power to the load.

Particularly, the power supply system according to the embodiment includes a plurality of power storage units each causing one and the other of different thermal reactions, i.e., a heat absorbing reaction and a heat generating reaction depending on the charging and discharging operations. The power supply system collects thermal energy as electric energy by utilizing the thermal reactions (the heat absorbing reaction or the heat generating reaction) that occurs in each power storage unit.

The following description will be given on an embodiment in which the above power supply system is applied to an image forming apparatus.

### <A. Whole Structure>

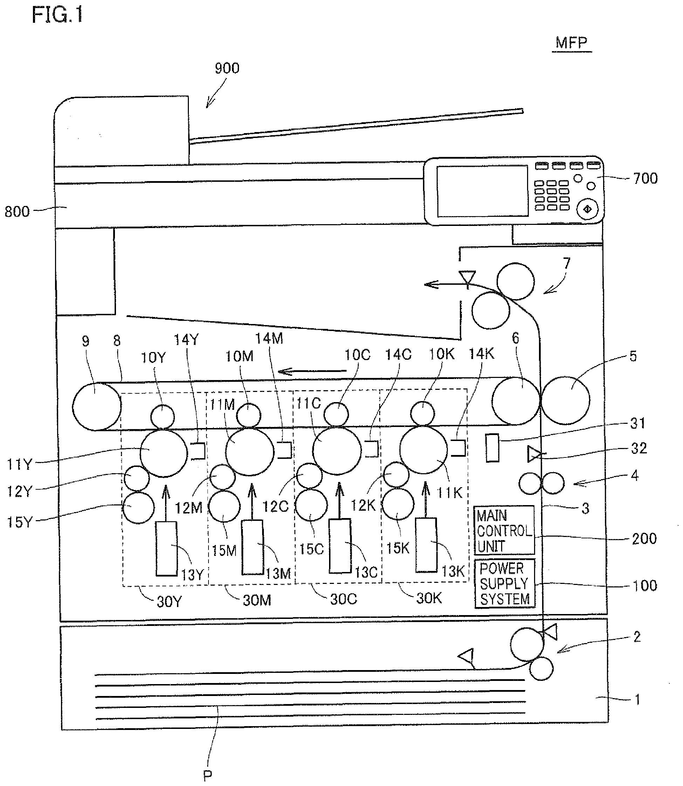

Referring to Fig. 1, a whole structure of an image forming apparatus MFP according to the embodiment of the invention will now be described. Fig. 1 illustrates image forming apparatus MFP equipped with a color print engine of a tandem type.

Image forming apparatus MFP has a print engine including a power supply system 100 and a main control unit 200. Typically, the print engine forms a color or monochrome image on a paper sheet P loaded in a sheet feed unit 1 based on image information that is obtained by optically reading contents of documents to be printed by an image scanner 800. Image scanner 800 is coupled to an Automatic Document Feeder (ADF) 900, which successively transports the documents to be printed.

More specifically, the print engine includes process units 30Y, 30M, 30C and 30K, which may be generally referred to as "process units 30", for four colors of yellow (Y), magenta (M), cyan (C) and black (B). Process units 30 of the respective colors are aligned in a moving direction of a transfer belt 8 for successively forming the toner images of corresponding colors on transfer belt 8.

Process units 30Y, 30M, 30C and 30K include primary transfer rollers 10Y, 10M, 10C and 10K (which may be generally referred to as "primary transfer rollers 10" hereinafter), photoreceptors 11Y, 11M, 11C and 11K (which may be generally referred to as "photoreceptors 11" hereinafter), developing rollers 12Y, 12M, 12C and 12K (which may be generally referred to as "developing rollers 12" hereinafter), print heads 13Y, 13M, 13C and 13K (which may be generally referred to as "print heads 13" hereinafter), chargers 14Y, 14M, 14C and 14K (which may be generally referred to as "chargers 14" hereinafter) and toner units 15Y, 15M, 15C and 15K (which may be generally referred to as "toner units 15" hereinafter), respectively.

When each process unit 30 receives a print request corresponding to a user's operation on a console panel 700 or the like, process unit 30 forms a toner image of a corresponding color forming an image to be printed on photoreceptor 11, and transfers the toner image of the corresponding color thus formed onto transfer belt 8 in synchronization with other process units 30. In this operation, primary transfer roller 10 moves the toner image on photoreceptor 11 onto transfer belt 8.

First, in each process unit, charger 14 charges a surface of rotating photoreceptor 11, and print head 13 performs exposure on the surface of photoreceptor 11 according to information of the image to be printed. Thereby, an electrostatic latent image representing the toner image to be formed is formed on the surface of photoreceptor 11. Thereafter, developing roller 12 supplies toner from toner unit 15 onto the surface of photoreceptor 11 so that the electrostatic latent image is developed into a toner image. Primary transfer rollers 10 successively transfer the toner images formed on respective photoreceptors 11 onto transfer belt 8 that is rotated by a drive motor 9. Thereby, the respective toner images overlap with each other to form the toner image to be transferred onto paper sheet P.

The print engine includes a density sensor 31 that can sense a toner density on transfer belt 8 for stabilizing the density of the toner image to be printed.

A feed roller 2 takes out paper sheet P loaded in sheet feed unit 1. Paper sheet P thus taken out is transported by a transport roller 4 and others along a transport path 3. When paper sheet P reaches a timing sensor 32, transport roller 4 temporarily stops paper sheet P. In synchronization with an operation in which the toner image formed on transfer belt 8 reaches a secondary transfer roller 5, transport roller 4 transports paper sheet P to secondary transfer roller 5. Sheet P is fed such that a leading position of paper sheet P matches a leading end of the toner image formed on transfer belt 8.

Thereby, secondary transfer roller 5 and an opposed roller 6 transfer the toner image from transfer belt 8 onto paper sheet P. Typically, a predetermined potential, e.g., of about +200 V corresponding the electric charges of the toner image has been applied to secondary transfer roller 5. This generates a power electrically attracting the toner image on transfer belt 8 toward secondary transfer roller 5 so that the transfer onto paper sheet P is performed.

Further, a fixing device 7 applies heat and pressure to the toner image transferred onto paper sheet P and thereby fixes the toner image to paper sheet P. Paper sheet P bearing the fixed toner image is discharged to a discharge tray. Thereby, a series of print process is completed.

Main control unit 200 governs the whole processing of the above print process by the print engine. Details of main control unit 200 will be described later.

Power supply system 100 is connected to an external power supply (typically, a commercial AC power supply), and supplies required powers to respective loads included in the above print engine. Particularly, power supply system 100 has a power storing function, and uses the power stored therein for supplying the power in a lower power consumption mode and supplying the power to a large load consuming a large power.

### <B. Power Supply System and Main Control Unit>

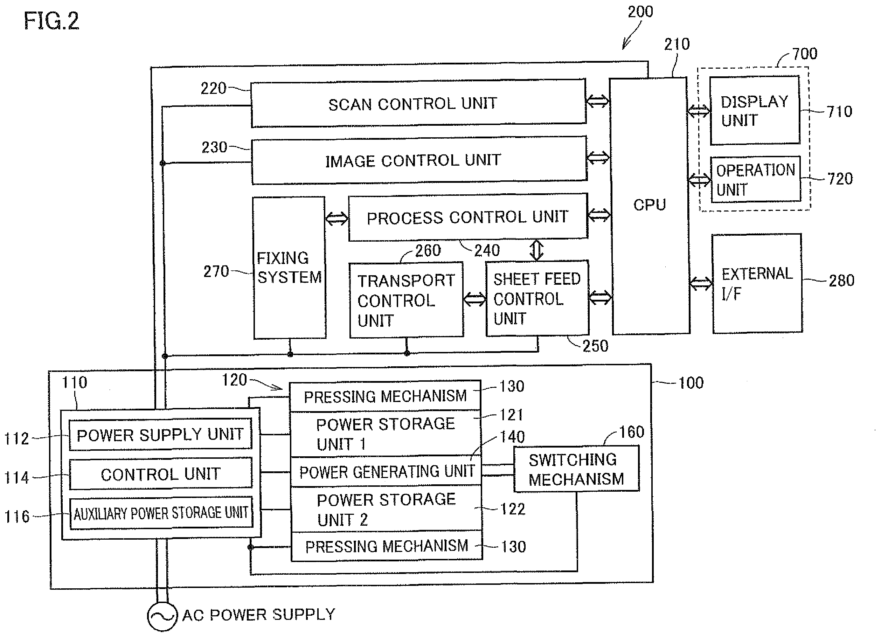

Referring now to Fig. 2, power supply system 100 and main control unit 200 shown in Fig. 1 will be described.

### (b 1. Power Supply System)

Power supply system 100 is arranged between an AC power supply and each load of the print engine including main control unit 200, and supplies a power of a kind corresponding to the load. Power supply system 100 includes a control module 110, a power storage module 120 and a switching mechanism 160.

Control module 110 supplies the power to the loads connected thereto, and controls the charging and discharging for power storage module 120 (precisely, power storage units 121 and 122 contained therein). More specifically, control module 110 includes a power supply unit 112, a control unit 114 and an auxiliary power storage unit 116.

Power supply unit 112 uses an AC power supplied from the AC power supply and thereby produces various kinds of powers (e.g., DC 48 V power supply, DC 12 V power supply and DC 3 V power supply) for driving the various loads of the print engine as well as the power for charging power storage module 120. Typically, power supply unit 112 is formed of a transducer, AC/DC converter (rectifier), DC/DC converter (switching regulator) and others.

Control unit 114 controls the supply of powers to the respective loads included in the print engine, and also controls the charge/discharge of power storage module 120. For example, image forming apparatus MFP according to the embodiment has the lower power consumption mode (sleep mode and standby mode) for suppressing the power consumption in addition to the mode (normal mode) allowing normal image formation processing. According to these operation modes of image forming apparatus MFP, control unit 114 controls the stopping of the power supply to the respective loads as well as the charge/discharge of the power storage modules of power storage module 120, According to the quantity of the power stored in power storage units, control unit 114 selectively performs the charging of the power storage units and the discharging thereof. A specific application example thereof will be described later.

Auxiliary power storage unit 116 supplies a required power when switching between the charge and discharge of the power storage units of power storage module 120 is performed as described later in the case where power supply unit 112 is at rest in the lower power consumption mode or the like. Auxiliary power storage unit 116 may supply the power for driving switching mechanism 160. For example, auxiliary power storage unit 116 is formed of a power storage cell such as an electric double layer capacitor, a lithium ion battery or a lithium ion capacitor.

Power storage module 120 includes power storage units 121 and 122, a power generating unit 140 and a pressing mechanism 130.

Power storage units 121 and 122 are formed of power storage cells that cause one of the heat absorbing reaction and the heat generating reaction in the charging operation and cause the other in the discharging operation. Typically, in power storage units 121 and 122, the heat absorbing reaction occurs when the charging operation is performed, and the heat generating reaction occurs when the discharging operation is performed. Specifically, power storage units 121 and 122 include the power storage cells formed of the lithium ion capacitors or lithium ion polymers. At present, the development of the cell material is rapidly advancing. Therefore, the power storage cell is not restricted to the above lithium-containing cells, and any kind of secondary battery can be employed in the power supply system according to the embodiment provided that the power storage cell causes the heat generating reaction in the charging operation and causes the heat absorbing reaction in the discharging operation.

Typically, each of power storage units 121 and 122 is configured to provide a required terminal voltage by connecting a required number of unit cells in series (or in parallel, when necessary).

Power generating unit 140 includes a thermoelectric converting element, and utilizes the thermal reaction occurring in power storage units 121 and 122 to generate the electric power. Power storage units 121 and 122 are spaced from each other by a predetermined distance for causing a temperature difference between them. Power generating unit 140 can contact with both power storage units 121 and 122 concurrently, and generates an electromotive force by utilizing the temperature difference between power storage units 121 and 122.

In power supply system 100 according to the embodiment, control unit 114 allows one of power storage units 121 and 122 to perform discharging, and allows the other to perform charging. This control causes different thermal reactions in power storage unit 121 located on the upper side in the figure of power generating unit 140 and power storage unit 122 located on the lower side thereof in the figure, respectively. Thus, one of the power storage units causes the heat absorbing reaction to lower the temperature, and the other causes the heat generating reaction to raise the temperature. As described above, power generating unit 140 is in contact with two power storage units 121 and 122 of different temperatures, and thereby performs the power generation by utilizing the temperature difference occurring between these two portions.

The sizes and positions of the portion where power generating unit 140 are in contact with the two power storage units can be appropriately designed according to the structures of a thermoelectric converting device in power generating unit 140.

In this specification, "to be dischargeable" means a state in which the power stored in the power storage unit in question is being discharged, or a state in which conditions are satisfied and the power can be discharged. For example, "to be dischargeable" can contain a case where the power storage unit is electrically connected to a path for supplying a power to a load but the load does not demand the power. Likewise, "to be chargeable" means a state in which the power storage unit in question is storing the power (i.e., is being charged), or a state in which conditions are satisfied and the charging can be performed.

In power supply system 100 according to the embodiment, it is not necessary to cause concurrently the discharging from one of the power storage units and the charging of the other. This is because power generating unit 140 can utilize the temperature difference when the thermal reaction has occurred in at least one of the power storage units. Thus, in the power storage system according to the embodiment, power generating unit 140 can perform the power generation even when only one of two power storage units 121 and 122 in contact with power generating unit 140 performs the discharging or the charging, and the other performs neither the discharging nor the charging.

According to the charge/discharge states of power storage units 121 and 122, switching mechanism 160 switches a state between a first contact state where it brings one and the other of the surfaces of power generating unit 140 into contact with power storage units 121 and 122, respectively, and a second contact state in which it conversely brings the one and the other of the surfaces of power generating unit 140 into contact with power storage units 122 and 121, respectively. Thus, a form of utilizing the temperature difference (i.e., a form of specifically determining the portions to be higher and lower in temperature, respectively) is predetermined in power generating unit 140. Therefore, the contact portions of power generating unit 140 that are in contact with power storage units 121 and 122, respectively, must be inverted in response to the switching between the charging and discharging operations in power storage units 121 and 122.

Control unit 114 performs switching according to predetermined conditions between a first charge/discharge state in which power storage unit 121 is dischargeable and power storage unit 122 is chargeable, and a second charge/discharge state in which power storage unit 121 is chargeable and power storage unit 122 is dischargeable. In response to the switching of the charge/discharge state by control unit 114, switching mechanism 160 performs the switching between the first and second contact states described before.

Pressing mechanism 130 enhances a degree of intimate contact between power storage unit 121 and power generating unit 140 as well as a degree of intimate contact between power storage unit 122 and power generating unit 140. More specifically, pressing mechanism 130 applies a pressure to one or both of the sides of each of power storage unit 121, power generating unit 140 and power storage unit 122. When pressing mechanism 130 performs the switching between the first and second contact states, it releases the pressure from power storage units 121 and 122 as well as power generating unit 140.

### (b2. Main Control Unit)

Referring to Fig. 2, main control unit 200 includes a CPU (Central Processing Unit) 210, a scan control unit 220, an image control unit 230, a process control unit 240, a sheet feed control unit 250, a transport control unit 260, a fixing system 270 and an external interface (I/F) 280.

CPU 210 governs the whole control of main control unit 200. Typically, CPU 210 executes program commands stored in a memory (not shown) to provide various functions.

Scan control unit 220 controls an image scan operation performed on document by image scanner 800, document feeding by an automatic document feeder 900 in accordance with to an instruction provided from CPU 210. Image control unit 230 produces image data suitable for image formation by performing necessary image processing on images scanned by image scanner 800 or the like.

In accordance with an instruction from CPU 210, process control unit 240 cooperates with sheet feed control unit 250, transport control unit 260 and fixing system 270 to provide the image formation process. Sheet feed control unit 250 controls the feeding of paper sheets P loaded in sheet feed unit 1. Transport control unit 260 controls the transport of paper sheet P along transport path 3. Fixing system 270 controls the fixing processing performed by fixing device 7 and the like. In an application example 2 to be described later, description will be given on processing in the case where fixing system 270 uses the power rapidly discharged from power storage module 120 to raise the temperature of fixing device 7.

External interface 280 is connected to peripheral devices and a network to transmit required information between CPU 210 and devices connected thereto.

CPU 210 is also connected to console panel 700 for displaying information according to the process on a display unit 710 of console panel 700 and accepting an instruction issued by a user's operation on an operation unit 720 of console panel 700.

### <C. Power Generating Unit>

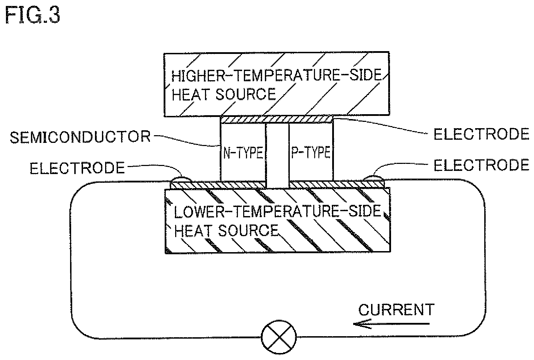

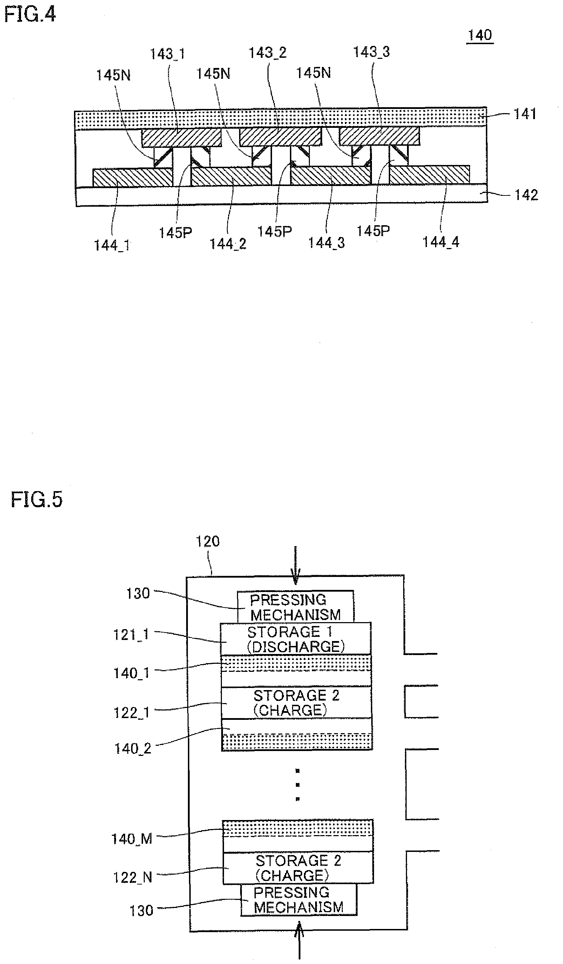

Referring now to Figs. 3 and 4, description will be given on power generating unit 140 according to the embodiment.

The thermoelectric conversion is an energy converting phenomenon utilizing a mutual reaction between electricity and heat. Power generating unit 140 according to the embodiment utilizes a Seebeck effect as the thermoelectric conversion (i.e., conversion from thermal energy to electric energy).

The Seebeck effect is a phenomenon in which a certain substance having a temperature difference generates a thermal electromotive force between its opposite ends. In general, when a temperature difference of 1 K occurs between the opposite ends, metal generates the thermal electromotive force of about several micro-volts, and semiconductor generates the thermal electromotive force between several tens to several hundreds of micro-volts.

Referring to Fig. 3, a thermoelectric converting device that forms power generating unit 140 according to the embodiment is, for example, a device having a so-called π-type structure, i.e., a structure in which P- and N-type semiconductors are combined together in series. According to the structure shown in Fig. 3, a plurality of P-type semiconductors and a plurality of N-type semiconductors are alternately arranged in series, and thereby the thermal electromotive force (terminal voltage) occurring between the opposite ends can be arbitrarily designed.

The P- and N-type semiconductors are different from each other in direction of the temperature difference required for causing the thermal electromotive force. As shown in Fig. 3, therefore, the portion in contact with the higher-temperature heat source (i.e., a surface on the upper side in the figure according to the example shown in Fig. 3) and the portion in contact with the lower-temperature heat source (i.e., a surface on the lower side in the figure according to the example shown in Fig. 3) are determined in advance.

Referring to Fig. 4, power generating unit 140 has a structure in which N- and P-type semiconductors 145N and 145P serving as the thermoelectric converting elements are electrically and alternately connected together. Thus, it includes a higher-temperature-side heat transfer plate 141 and a lower-temperature-side heat transfer plate 142 opposed to each other with a predetermined distance therebetween. Higher-temperature-side electrodes 143_1, 143_2 and 143_3 are arranged in contact with higher-temperature-side heat transfer plate 141, and thermal energy is transmitted between these higher-temperature-side electrodes and the power storage unit through higher-temperature-side heat transfer plate 141.

Lower-temperature-side electrodes 144_1, 144_2 and 144_3 are arranged in contact with lower-temperature-side heat transfer plate 142, and thermal energy is transmitted between these lower-temperature-side electrodes and the power storage unit through lower-temperature-side heat transfer plate 142.

Thus, the temperatures of higher-temperature-side electrodes 143_1, 143_2 and 143_3 as well as lower-temperature-side electrodes 144_1, 144_2 and 144_3 are designed to be substantially equal to the surface temperatures of the power storage units in contact with them, respectively.

The N- or P-type semiconductor is electrically connected between the higher-temperature-side electrode and the lower-temperature-side electrode neighboring to each other, and each of such semiconductors generates the thermal electromotive force corresponding to the temperature difference. Therefore, the terminal voltage appearing between the opposite ends of power generating unit 140 is equal to a sum of the thermal electromotive forces that are generated by N- and P-type semiconductors 145N and 145P, respectively.

Fig. 4 shows an example of the structure having seven electrodes in total and six semiconductors in total, for the sake of simplicity. However, these numbers can be arbitrarily designed corresponding to the required design values and situations,

The semiconductor providing such Seebeck effect may be a bismuth-tellurium-containing (Bi-Te containing) semiconductor. Also, a lead-tellurium-containing (Pb-Te-containing) or silicon-germanium-containing (Si-Ge-containing) semiconductor may be used depending on the surface temperatures of power storage units 121 and 122.

Higher- and lower-temperature-side heat transfer plates 141 and 142 that are portions of power generating unit 140 in contact with the respective power storage units are preferably configured to have areas equal to or smaller than areas of power storage units 121 and 122 in contact with them, respectively. Thus, the contact surfaces of power storage units 121 and 122 are preferably equal to or larger than higher- and lower-temperature-side heat transfer plates 141 and 142, respectively. This is because the magnitude of the thermal electromotive force generated by each of N- and P-type semiconductors 145N and 145P is variable depending on the temperature difference, and therefore it is preferable for maintaining the stable terminal voltage to uniformize the temperature distribution so that partial irregularities in temperature may not occur on each of higher- and lower-temperature-side heat transfer plates 141 and 142.

### <D. Structure and Operation of Power Storage Module>

Referring to Figs. 5 to 11, description will be given on the structure and operation of power storage module 120 according to the embodiment.

### (d1. Arrangement of Power Storage Unit and Power Generating Unit)

Power storage module 120 according to the embodiment implements the intended function when it includes at least one pair of power storage units 121 and 122 as well as one power generating unit 140. However, when single power generating unit 140 may not provide a sufficiently high terminal voltage, it is preferable to arrange the plurality of power generating units 140. Accordingly, in a practical form, as shown in Figs. 5 to 11, the plurality of power storage units are arranged, and power generating units 140 are arranged in respective positions between power storage units neighboring to each other.

For example, power storage module 120 according to the embodiment includes power storage units 121_1, 121_2, ··· 121_N of N in number in a first group (which may be generally referred to as "power storage units 121 in the first group" hereinafter), power storage units 122_1, 122_2, ··· 122_N of N in number in a second group (which may be generally referred to as "power storage units 122 in the second group" hereinafter), and power generating units 140_1, 140_2, ··· 140_M (which may be generally referred to as "power generating units 140" hereinafter) of M in number. In the figures, for the sake of understanding, each power storage unit 121 in the first group is shown as "POWER STORAGE UNIT 1" and each power storage unit 122 in the second group is shown as "POWER STORAGE UNIT 2".

Power storage units 121 in the first group and power storage units 122 in the second group complementarily perform the charging operation and the discharging operation. Thus, when power storage units 121_1, 121_2, ··· 121_N in the first group are chargeable, power storage units 122_1, 122_2, ··· 122_N in the second group are dischargeable. Conversely, when power storage units 121_1, 121_2, ··· 121_N in the first group are dischargeable, power storage units 122_1, 122_2, ··· 122_N in the second group are chargeable.

In power storage module 120, power storage units 121 in the first group are arranged alternately, in the longitudinal direction in the figure, to power storage units 122 in the second group. Each of power generating units 140 is arranged between power storage unit 121 in the first group and power storage unit 122 in the second group. Therefore, when each of the first and second groups includes power storage units 121 or 122 of N in number, power generating units 140 of (2N - 1) in number are arranged.

Further, pressing mechanisms 130 that can apply the pressure in the longitudinal direction in the figure are arranged outside power storage units 121 and 122 in the first and second groups and the plurality of power generating units 140.

Thus, portions of power generating unit 140 that are in contact with power storage units 121 and 122, respectively, are a pair of opposite surfaces of power generating unit 140, i.e., higher- and lower-temperature-side heat transfer plates 141 and 142 shown in Fig. 4. Power storage units 121 in the first group and power storage units 122 in the second group are aligned in the direction perpendicular to the contact surface of power generating unit 140 so that power generating unit 140 may be positioned between the two neighboring power storage units. Pressing mechanism 130 applies a pressure toward at least one of the contact surfaces of power generating unit 140.

Figs. 5 to 11 show the structure in which pressing mechanisms 130 arranged on the opposite sides, respectively. However, one of the end surfaces may be fixed, and pressing mechanism 130 arranged on only the other side may apply the pressure.

### (d2. Charge and Discharge Operations and Power Generating Operation)

Fig. 5 shows an example of a steady state of power storage module 120 according to the embodiment. Fig. 5 shows a case in which power storage units 121_1, 121_2, ··· 121_N in the first group are dischargeable, and power storage units 122_1, 122_2, ··· 122_N in the second group are chargeable.

In this steady state, when power storage units 121_1, 121_2, ··· 121_N in the first group are discharged, the heat generating reaction raises the temperature of power storage units 121_1, 121_2, ··· 121_N in the first group. When power storage units 122_1, 122_2, ··· 122_N in the second group are charged, the heat absorbing reaction lowers the temperature of power storage units 122_1, 122_2, ··· 122_N in the second group.

Therefore, each of power generating units 140_1, 140_2, ··· 140_M is configured such that power storage unit 121 in the first group is positioned on the side corresponding to higher-temperature-side heat transfer plate 141, and power storage unit 122 in the second group is positioned on the side of lower-temperature-side heat transfer plate 142.

In other words, the power storage unit in contact with higher-temperature-side heat transfer plate 141 of power generating unit 140 is rendered dischargeable by control unit 114 of control module 110, and the power storage unit in contact with lower-temperature-side heat transfer plate 142 of power generating unit 140 is rendered chargeable by the same.

In Figs. 5 to 11, the side on which higher-temperature-side heat transfer plate 141 is located in power generating unit 140 is hatched for the sake of understanding.

The positional relationship of power generating units 140 and the charge/discharge states of power storage units 121 and 122 that are set as shown in Fig. 5 causes the temperature difference between the surfaces of power generating unit 140, i.e., the surfaces located on the upper and lower sides in the figure, respectively. Power generating unit 140 generates the predetermined thermal electromotive force depending on this temperature difference. The current generated by this thermal electromotive force becomes the electric energy collected from the thermal energy.

In the state shown in Fig. 5, conditions about the remaining quantities of the powers in power storage units 121 and/or 122 in the first and/or second group or other conditions are satisfied, the charge/discharge state is switched. Determination about the remaining quantity in the power storage unit is typically performed by a comparison between the terminal voltage and a predetermined threshold. Alternatively, the current supplied to each power storage unit and the current discharged from each power storage unit may be successively measured, and the remaining quantity in the battery may be estimated by calculating the difference between them.

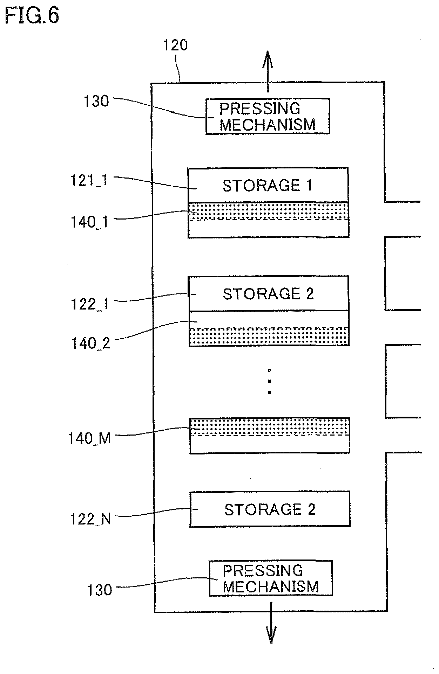

In this switching operation, as shown in Fig. 6, pressing mechanism 130 first releases the pressure from power storage units 121 and 122 as well as power generating units 140. Thereby, each power generating unit 140 is released from power storage units 121 and 122 in the first and second groups neighboring thereto.

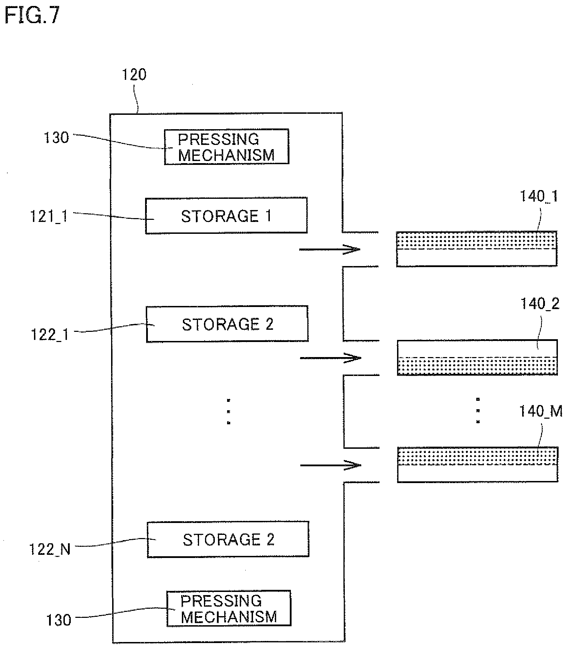

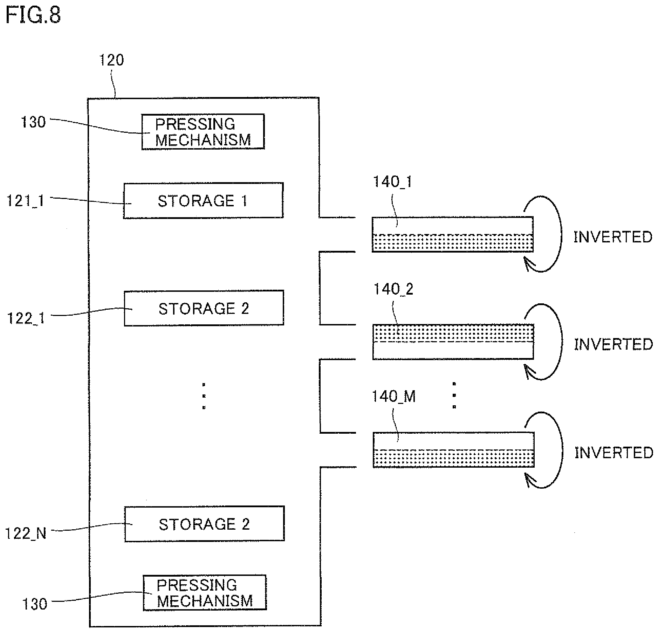

Subsequently, as shown in Fig. 7, switching mechanism 160 (not shown) slides each power generating unit 140 in the lateral direction in the figure. Further, as shown in Fig. 8, switching mechanism 160 inverts each power generating unit 140. Thus, switching mechanism 160 inverts the direction of each power generating unit 140 to locate higher-temperature-side heat transfer plate 141 on the lower side in the figure.

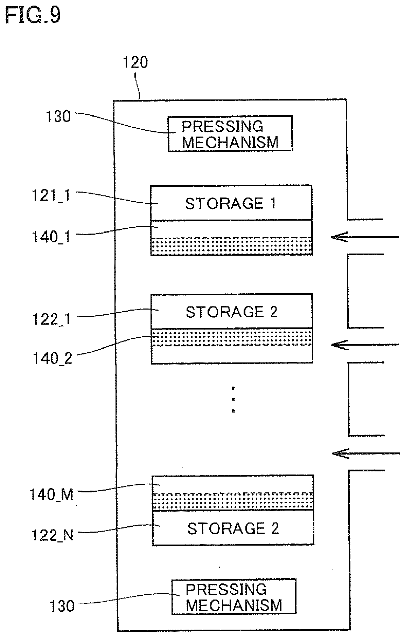

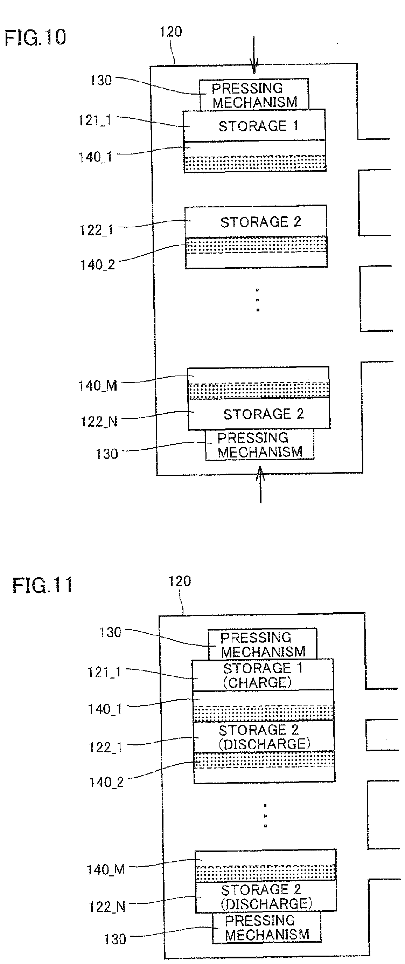

Thereafter, as shown in Fig. 9, switching mechanism 160 returns each power generating unit 140 thus inverted to the position where it can make contact with power storage units 121 and 122. Finally, as shown in Fig. 10, pressing mechanism 130 applies the pressure to power storage units 121 and 122 as well as power generating unit 140 again.

As shown in Fig. 11, power storage units 121 and 122 in the first and second groups switch their charge/discharge states so that power storage units 121_1, 121_2, ··· 121_N in the first group become chargeable, and power storage units 122_1, 122_2, ··· 122_N in the second group become dischargeable, Consequently, in each power generating unit 140, power storage unit 122 in the second group at a higher temperature comes into contact with higher-temperature-side heat transfer plate 141, and power storage unit 121 in the first group at a lower temperature comes into contact with lower-temperature-side heat transfer plate 142. Therefore, each power generating unit 140 can continue generation of the thermal electromotive force.

During the operation of replacing power generating units 140, the state in which power storage units 121 in the first group are electrically isolated from power storage units 122 in the second group may continue. In this case, auxiliary power storage unit 116 of control module 1 10 supplies a required power.

### (d3. Switching Mechanism)

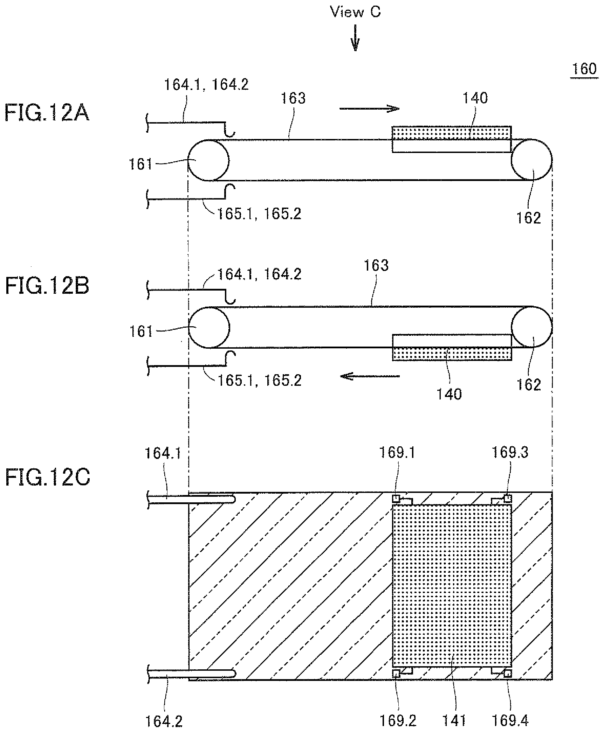

The mechanism of inverting the direction of power generating unit 140 (i.e., turning it upside down) as described above may take any form, but typically can employ a mechanism of belt drive as shown in Figs. 12A - 12C.

Switching mechanism 160 in power supply system 100 according to the embodiment of the invention includes a circulation belt 163 arranged between rotation rollers 161 and 162. Power generating units 140 having a sheet-like form are formed on circulation belt 163. Each of circulation belt 163 and power generating units 140 is made of a flexible material. Therefore power generating units 140 can be inverted by controlling rotation rollers 161 and 162 to rotate circulation belt 163.

Circulation belt 163 is partially provided with an opening for allowing stable contact of the opposite surfaces of power generating unit 140.

Fig. 12A shows a state in a certain point in time of the foregoing process shown in Figs, 6 and 7, and Fig. 12B shows a state in a certain point in time of the foregoing process shown in Figs. 8 and 9. Fig. 12C is a plan taken downward in Fig. 12A.

On circulation belt 163, there are formed terminal electrodes 169.1 and 169.3 connected to positive output terminals of power generating unit 140 as well as terminal electrodes 169.2 and 169.4 connected to negative output terminals of power generating unit 140.

Further, connector terminals 164.1 and 165.1 are arranged on movement axes of terminal electrodes 169.1 and 160.3, respectively, and connector terminals 164.2 and 165.2 are arranged on movement axes of terminal electrodes 169.2 and 169.4, respectively. Connector terminals 164.1 and 164.2 are arranged on the upper side in the figure with respect to circulation belt 163, and connector terminals 165.1 and 165.2 are arranged on the lower side in the figure with respect to circulation belt 163.

In a normal state, these connector terminals 164.1, 164.2, 165.1 and 165.2 are held in positions spaced by predetermined distances from circulation belt 163, respectively. When pressing mechanism 130 applies the pressure to power storage units 121 and 122, connector terminals 164.1 and 164.2 come into electrical contact with terminal electrodes 169.1 and 169.2, respectively, in the case where power generating unit 140 is located on the upper side in the figure, In the case where power generating unit 140 is located on the lower side in the figure, connector terminals 165.1 and 165.2 come into electrical contact with terminal electrodes 169.3 and 169.4, respectively.

Thus, when power generating unit 140 is located on the upper side in the figure, the power is taken out from power generating unit 140 through terminal electrodes 169.1 and 169.2. When power generating unit 140 is located on the lower side in the figure, the power is taken out from power generating unit 140 through terminal electrodes 169.3 and 169.4.

### (d4. Charge/discharge Circuit)

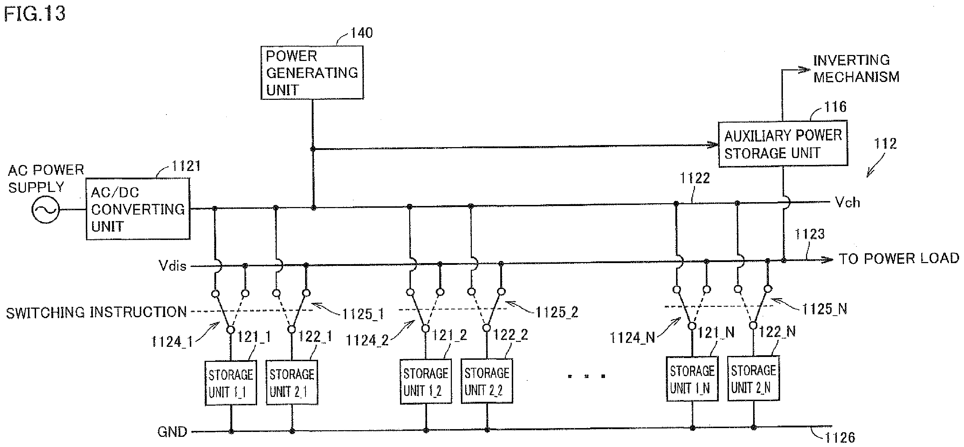

Referring to Fig. 13, description will be given on the circuit structure for switching the charge/discharge states of the foregoing power storage units in the first and second groups.

Power supply unit 112 includes an AC/DC converting unit 1121 for producing a DC power (charge voltage Vch) used for charging power storage unit 121 or 122 from the external AC power supply, a charge bus 1122 connected to an output side of AC/DC converting unit 1121, and a discharge bus 1123 for providing the power discharged from power storage unit 121 or 122 to the load.

Power storage units 121_1, 121_2, ··· 121_N in the first group can be electrically connected between charge bus 1122 and a ground line 1126 or between discharge bus 1123 and ground line 1126. Thus, power storage units 121_1, 121_2, ··· 121_N are electrically connected to charge bus 1122 or discharge bus 1123 through switches 1124_1, 1124_2, ··· 1124_N in the first group, respectively.

Likewise, power storage units 122_1, 122_2, ··· 122_N in the second group can be electrically connected between charge bus 1122 and ground line 1126 or between discharge bus 1123 and ground line 1126. Thus, power storage units 122_1, 122_2, ··· 122_N are electrically connected to charge bus 1122 or discharge bus 1123 through switches 1125_1, 1125_2, ··· 1125_N in the second group, respectively.

Switches 1124_1, 1124_2, ··· 1124_N in the first group and switches 1125_1, 1125_2, ··· 1125_N in the second group perform the switching operations complementarily to each other in response to a switching construction provided from control unit 114 of control module 110. Thus, when power storage units 121 in the first group are set to the dischargeable state, switches 1124_1, 1124_2, ··· 1124_N in the first group electrically connect corresponding power storage units 121 in the first group to charge bus 1122, respectively, and switches 1125_1, 1125_2, ··· 1125_N in the second group electrically connect corresponding power storage units 122 in the second group to discharge bus 1123, respectively. When power storage units 122 in the second group are set dischargeable, operations opposite to the above are performed.

Owing to the above circuit structure, the state can be switched between the first charge/discharge state in which power storage units 121 in the first group are dischargeable and power storage units 121 in the second group are chargeable and the second charge/discharge state in which power storage units 121 in the first group are chargeable and power storage units 122 in the second group 122 are dischargeable.

Power generating units 140 that generate the power corresponding to the temperature difference between power storage units 121 and 122 in the first and second groups are electrically connected to charge bus 1122. Further, power generating units 140 may be electrically connected to auxiliary power storage unit 116 of control module 110.

Thus, control unit 114 of control module 110 charges power storage units 121 or 122 in the first or second group, using the power generated by power generating unit 140. Alternatively, control unit 114 charges auxiliary power storage unit 116 of control module 110, using the power generated by power generating unit 140.

The output side of auxiliary power storage unit 116 may be electrically connected to discharge bus 1123. Alternatively, the output side of auxiliary power storage unit 116 is electrically connected to switching mechanism 160 (Fig. 2). Thus, switching mechanism 160 is driven by the power supplied from auxiliary power storage unit 116.

### <E. Application Example 1>

As an example of application of power supply system 100 according to the embodiment, description will be given on a control example in the case where it functions as a substitute or alternative power supply when image forming apparatus MFP enters a lower power consumption mode.

First, image forming apparatus MFP according to an application example 1 of the embodiment is switchable between the normal mode that can perform the normal operation such as print processing and the lower power consumption mode for suppressing the power consumption. In the lower power consumption mode, the power consumed by the loads is reduced, and the power supply device (e.g., a switching regulator) for supplying the power to these loads stops its operation. Thereby, the power loss (switching loss) in the power supply device can be zero. In this state, power storage module 120 supplies the alternative power.

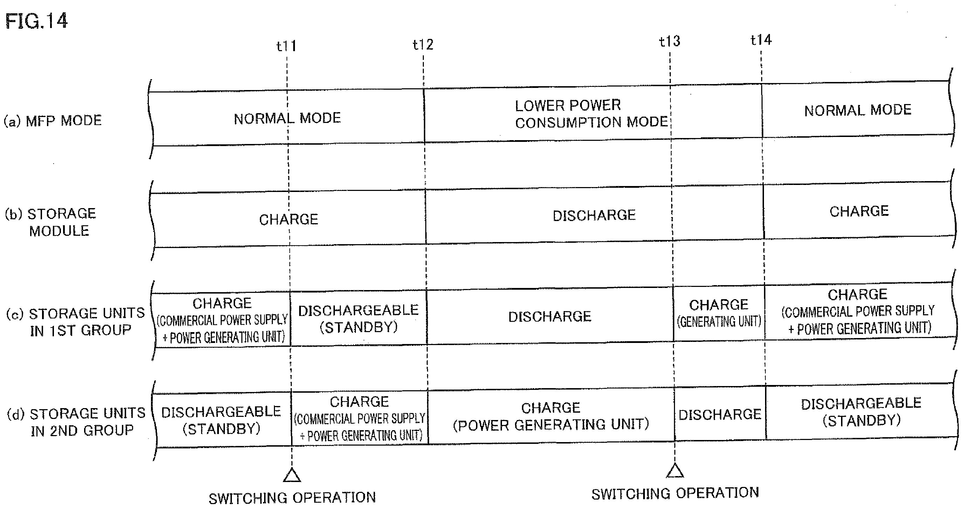

Fig. 14 is a time chart showing an example of the operation according to the application example 1 of the embodiment of the invention. Fig. 14 shows changes that occur with time in (a) operation mode in image forming apparatus MFP, (b) charge/discharge state in power storage module 120, (c) charge/discharge state of power storage units 121 in the first group and (d) charge/discharge state of power storage units 122 in the second group.

As shown at (a) in Fig. 14, the operation mode of image forming apparatus MFP changes from the "normal mode" to the "lower power consumption mode" at a time t12, and changes from the "lower power mode consumption" to the "normal mode" at a time t14.

As shown at (b) in Fig. 14, power storage module 120 performs, as a whole, the charging operation while image forming apparatus MFP is in the "normal mode", and performs, as a whole, the discharging operation while image forming apparatus MFP is in the "lower power consumption mode". However, the state of power storage units 121 in the first group and the state of power storage units 122 in the second group forming power storage module 120 are appropriately switched between the chargeable state and the dischargeable state depending on the quantities of stored powers.

For example, at or before a time t11, power storage units 121 in the first group are chargeable, and power storage units 122 in the second group are dischargeable. In this state, the operation mode of image forming apparatus MFP is the "normal mode" so that power storage units 121 in the first group are charged with the power supplied from the commercial power supply, and power storage units 122 in the second group 122 are on standby. In this state, the charging operation performed on power storage units 121 in the first group causes the heat absorbing reaction, and power generating units 140 generate the power as a result of the temperature difference caused by this heat absorbing reaction. A whole or part of the power generated by power generating units 140 is used for charging power storage units 121 in the first group.

At time t11, it is determined that the quantity of stored power of power storage units 121 in the first group has reached an upper limit. Typically, this is determined based on whether the terminal voltage of power storage unit 121 in the first group is equal to or higher than a predetermined threshold or not.

At time t11, the switching operation is executed. Thus, control unit 114 switches the state of power storage units 121 in the first group from the chargeable state to the dischargeable state, and switches the state of power storage units 122 in the second group from the dischargeable state to the chargeable state. In synchronization with this, control unit 114 provides an instruction to switching mechanism 160 to switch the contact state of power generating units 140. Thereby, power storage units 122 in the second group are charged with the power provided from the commercial power supply. In this state, similarly to the above, the charging operation performed on power storage units 122 in the second group causes the heat absorbing reaction, and the temperature difference caused by this heat absorbing reaction causes power generating units 140 to generate the power. A whole or part of the power generated by power generating units 140 is used for charging power storage units 122 in the second group.

At subsequent time t12, the operation mode of image forming apparatus MFP changes from the "normal mode" to the "lower power consumption mode" so that dischargeable power storage units 121 in the first group start the power supplying (discharging) to the load. In this state, the discharging operation performed in power storage units 121 in the first group causes the heat generating reaction, and the temperature difference caused by this heat generating reaction causes power generating units 140 to generate the power. A whole or part of the power generated by power generating units 140 is used for charging power storage units 122 in the second group.

At a subsequent time t13, it is determined that the quantity of stored power of power storage units 121 in the first group reaches a lower limit. Typically, the determination is performed based on whether the terminal voltage of power storage units 121 in the first group is equal to or lower than the predetermined threshold, or not.

Thereby, the switching operation takes places at time t13. Thus, control unit 114 switches the state of power storage units 121 in the first group from the dischargeable state to the chargeable state, and switches the state of power storage units 122 in the second group from the chargeable state to the dischargeable state. In synchronization with this, control unit 114 provides an instruction to switching mechanism 160 to switch the contact state of power generating units 140. Thereby, power storage units 122 in the second group start the power supplying (discharge) to the load. In this state, the discharging operation of power storage units 122 in the second group causes the heat absorbing reaction, and the temperature difference caused by this heat generating reaction causes power generating units 140 to generate the power. A whole or part of the power generated by power generating units 140 is used for charging power storage units 121 in the first group.

When the operation mode of image forming apparatus MFP changes from the "lower power consumption mode" to the "normal mode" at time t14, the operation similar to that at and before time t11 already described is executed.

Then, description will be given on the processing procedure for implementing the operation shown in Fig. 14.

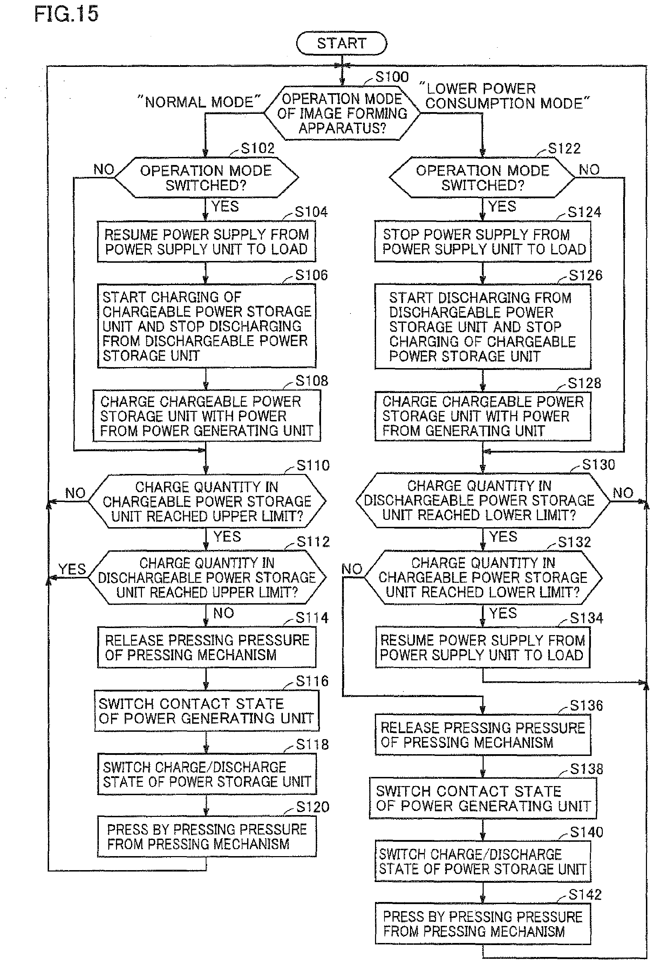

Fig. 15 is a flowchart showing a processing procedure according to the application example 1 of the embodiment of the invention. Typically, control unit 114 of control module 110 executes steps shown in Fig. 15.

Referring to Fig. 15, control unit 114 determines the operation mode of image forming apparatus MFP (step S100). When the operation mode is the "normal mode" ("NORMAL MODE" in step S100), the process proceeds to a step S102. Conversely, when the operation mode is the "lower power consumption mode" ("LOWER POWER CONSUMPTION MODE" in step S100), the process proceeds to a step S122.

In step S102, control unit 114 determines whether switching of the operation mode of image forming apparatus MFP took place between a last computation period and a present computation period, or not. Thus, control unit 114 determines that the operation mode was switched when the operation mode in the last computation period is the "lower power consumption mode" and the operation mode in the current computation period is the "normal mode". When the operation mode of image forming apparatus MFP was switched (YES in step S102), the processing proceeds to a step S104. Conversely, when the operation mode of image forming apparatus MFP was not switched (NO in step S102), the process proceeds to a step S110.

In step S104, control unit 114 resumes the power supply from power supply unit 112 to the load. In a subsequent step S106, control unit 114 starts the charging of the chargeable power storage unit, using the power supplied from the commercial power supply, and stops the discharging from the dischargeable power storage unit. In a step S108, control unit 114 forms a circuit so that the chargeable power storage unit may be charged with the power generated by power generating unit 140. Thereafter, the process proceeds to step S110.

In step S110, control unit 114 determines whether the quantity of stored power in the chargeable power storage unit has reached an upper limit or not. When the quantity of stored power in the chargeable power storage unit has not reached the upper limit (NO in step S110), the process returns to step S100.

Conversely, when the quantity of stored power in the chargeable power storage unit has reached the upper limit (YES in step S110), control unit 114 determines whether the quantity of stored power in the other (i.e., dischargeable) power storage unit has reached the upper limit or not (step S112). When the quantity of stored power in the other, i.e., dischargeable power storage unit has reached the upper limit (YES in step S112), this means that each power storage unit is fully charged so that control unit 114 does not perform the switching operation. Then, the process returns to step S100.

Conversely, when the quantity of stored power in the other, i.e., dischargeable power storage unit has not reached the upper limit (NO in step S112), control unit 114 executes the processing in steps S114 - S118 described below.

In step S114, control unit 114 provides an instruction to pressing mechanism 130 to release the pressing pressure applied from pressing mechanism 130. In a subsequent step S116, control unit 114 provides an instruction to switching mechanism 160 so that switching mechanism 160 changes the contact state of power generating unit 140. In subsequent step S18, control unit 114 provides an instruction to power supply unit 112 so that power supply unit 112 changes the charge/discharge state of the power storage unit. In a subsequent step S120, control unit 114 provides an instruction to pressing mechanism 130 to perform the pressing again by the pressing pressure applied from pressing mechanism 130. Then, the process returns to step S100.

In step S122, control unit 114 determines whether the switching of the operation mode of image forming apparatus MFP took place between the last computation period and the present computation period, or not. Thus, control unit 114 determines that the operation mode was switched when the operation mode in the last computation period is the "normal mode" and the operation mode in the present computation period is the "lower power consumption mode". When the operation mode of image forming apparatus MFP was switched (YES in step S122), the process proceeds to step S124. Conversely, when the operation mode of image forming apparatus MFP was not switched (NO in step S122), the process proceeds to a step S130.

In step S124, control unit 114 stops the power supply from power supply unit 112 to the load. In a subsequent step S126, control unit 114 starts the power supplying (discharging) to from the dischargeable power storage unit to the load, and stops the charging of the chargeable power storage unit. In a step S128, control unit 114 forms the circuit so that the chargeable power supply unit can be charged with the power generated by power generating unit 140. Thereafter, the process proceeds to step S130.

In step S130, control unit 114 determines whether the quantity of stored power in the dischargeable power storage unit has reached the lower limit or not. When the quantity of stored power in the dischargeable power storage unit has not reached the lower limit (NO in step S130), the process returns to step S100.

Conversely, when the quantity of stored power in the dischargeable power storage unit has reached the lower limit (YES in step S130), control unit 114 determines whether the quantity of stored power in the other, i.e., chargeable power storage unit has reached the lower limit or not (step S 132). When the quantity of stored power in the other, i.e., chargeable power storage unit has reached the lower limit (YES in step S132), this means that neither of the power storage units has stored a sufficient quantity of power. Therefore, control unit 114 does not perform the switching operation. Alternatively, control unit 114 resumes the power supply to the load (step S134). Then, the process returns to step S100.

Alternatively, when the quantity of stored power in the chargeable, i.e., other power storage unit has not reached the lower limit (NO in step S132), control unit 114 executes the processing in steps S136 - S142 described below.

In step S136, control unit 114 provides an instruction to pressing mechanism 130 to release the pressing pressure applied from pressing mechanism 130. In a subsequent step S138, control unit 114 provides an instruction to switching mechanism 160 to switch the contact state of power generating unit 140 by switching mechanism 160. In a subsequent step S140, control unit 114 provides an instruction to power supply unit 112 to switch the charge/discharge state of the power storage unit by power supply unit 112. In subsequent step S142, control unit 114 provides an instruction to pressing mechanism 130 to perform pressing again by the pressing pressure applied from pressing mechanism 130. Then, the process returns to step S100.

### <F. Application Example 2>

As another example of application of power supply system 100 according to the embodiment, description will be given on a structure in which it is used as a power supply for raising a temperature of fixing device 7 of image forming apparatus MFP.

Image forming apparatus MFP according to an application example 2 of the embodiment is likewise switchable between the normal mode allowing normal operations such as print processing and the lower power consumption mode for suppressing the power consumption. Fixing device 7 of image forming apparatus MFP undergoes temperature control to attain a predetermined temperature for the stable image formation. In the lower power consumption mode, fixing device 7 is kept at a lower temperature for reducing the power consumption. For this, it is required to supply a relatively large power within a short time for raising the temperature of fixing device 7 in accordance with the mode switching from the lower power consumption mode to the normal mode. Also, it is required to reduce the power peak. The embodiment can comply with both the requirements.

Further, during a warm-up period after image forming apparatus MFP was powered on and before the print operation can start, it is required to raise the temperature of fixing device 7 within a relatively short time. Also, in the above state, it is possible to reduce the power peak for contributing to energy saving of the apparatus.

Image forming apparatus MFP according to an example of application, power supply system 100 supplies the power required for raising the temperature of fixing device 7. Employment of this structure can relatively reduce the capacity of the power supply device that is used for supplying the power required for raising the temperature of fixing device 7. Since the power supply unit stores the power in advance, it is easy to implement rapid discharging.

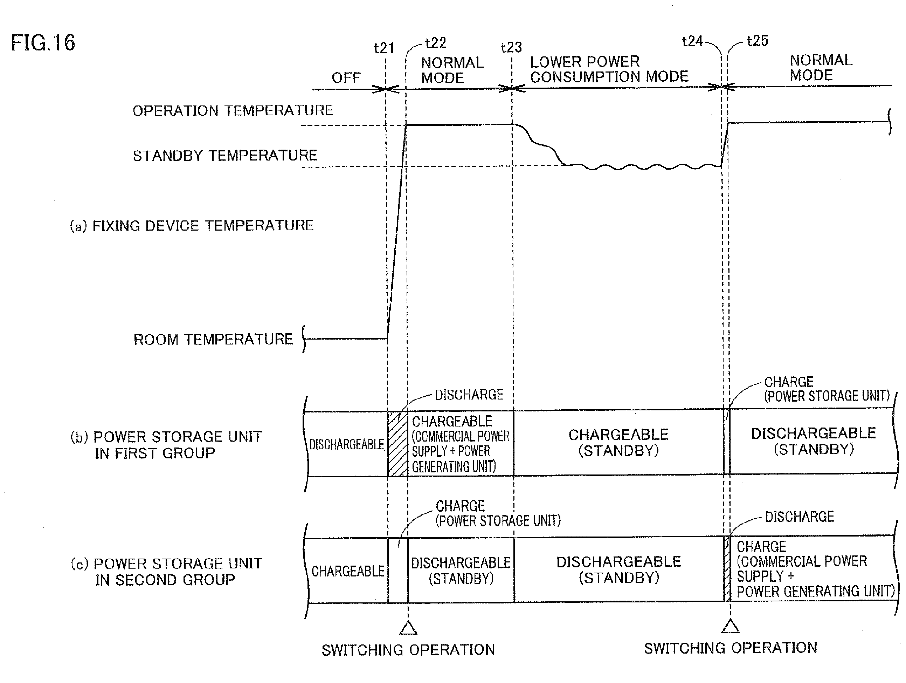

Fig. 16 is a time chart showing an example of an operation according to the application example 2 of the embodiment of the invention. Fig. 16 shows changes that occur with time in (a) fixing device temperature of fixing device 7, (b) charge/discharge state of power storage unit 121 in the first group and (c) charge/discharge state of power storage unit 122 in the second group.

As shown in Fig. 16, image forming apparatus MFP is powered on at a time t21, the operation mode of image forming apparatus MFP changes from the "normal mode" to the "lower power consumption mode" at a time t23, and the operation mode of image forming apparatus MFP changes from the "lower power consumption mode" to the "normal mode" at time t24.

As shown at (a) in Fig. 16, the fixing device temperature of fixing device 7 that was substantially equal to a room temperature before the power-on of image forming apparatus MFP will rapidly rise to an operation temperature after the power is turned on at time t21. A period between times t21 and t22 is required for raising the fixing device temperature from the room temperature to the operation temperature.

Thereafter, the fixing device temperature is kept at the operation temperature until the operation mode changes to the "lower power consumption mode" at time t23. After the operation mode changes from the "normal mode" to the "lower power consumption mode" at time t23, the fixing device temperature will be kept at a standby temperature. A commercial power supply is used for the above maintaining of the fixing device temperature at the operation temperature.

Thereafter, when the operation mode changes from the "lower power consumption mode" to the "normal mode" at time t24, the fixing device temperature rises from the standby state to the operation temperature. The power supplied from power supply system 100 is used for this temperature rising of the fixing device temperature.

Thereafter, the temperature control similar to the above is performed.

Description will be given on states of each power storage unit of power supply system 100 corresponding to the above control of the fixing device temperature.

For example, before time t21 (before power-on), power storage unit 121 in the first group is dischargeable and power storage unit 122 in the second group is chargeable. However, the power is not on so that the state may be unsettled in an actual configuration.

When image forming apparatus MFP is powered on at time t21, power storage unit 121 in the first group performs the power supplying (rapid discharging) to fixing device 7. In this operation, the discharging operation of power storage unit 121 in the first group causes the heat generating reaction, and power generating unit 140 generates the power owing to the temperature difference caused by this heat generating reaction. A whole or part of the power generated by power generating unit 140 is used for charging power storage unit 122 in the second group.

When the fixing device temperature reaches the operation temperature at time t22, the switching operation is executed. Specifically, control unit 114 switches the state of power storage unit 121 in the first group from the dischargeable state to the chargeable state, and switches the state of power storage unit 122 in the second group from the chargeable state to the dischargeable state. In synchronization with this, control unit 114 provides an instruction to switching mechanism 160 to switch the contact state of power generating unit 140.

In this operation, power storage unit 121 in the first group is charged with the power supplied from the commercial power supply. Similarly to the foregoing case, the charging operation performed on power storage unit 121 in the first group causes the heat absorbing reaction, and power generating unit 140 generates the power by the temperature difference caused by this heat absorbing reaction. A whole or part of the power generated by power generating unit 140 is used for charging power storage unit 121 in the first group. Conversely, power storage unit 122 in the second group is on standby.

At time t23, the operation mode changes from the "normal mode" to the "lower power consumption mode" so that the charging operation for power storage unit 122 in the first group stops, and the system enters the standby state. Even after this change or switching to the lower power consumption mode, the charging operation may continue until the quantity of stored power of power storage unit 122 in the first group reaches the upper limit.

Thereafter, at time t24, the operation mode of image forming apparatus MFP changes from the "lower power consumption mode" to the "normal mode" so that the power supplying (rapid discharging) from power storage unit 122 in the second group to fixing device 7 is performed. This discharging operation of power storage unit 122 in the second group causes the heat generating reaction, and power generating unit 140 generates the power owing to the temperature difference caused by this heat generating reaction. A whole or part of the power generated by power generating unit 140 is used for charging power storage unit 121 in the first group.

At time t25, the fixing device temperature rises from the standby temperature to the operation temperature, the switching operation is executed. Thus, control unit 114 switches the state of power storage unit 121 in the first group from the chargeable state to the dischargeable state, and switches the state of power storage unit 122 in the second group from the dischargeable state to the chargeable state. In synchronization with such switching, control unit 114 provides an instruction to switching mechanism 160 to change the contact state of power generating unit 140.

Thereafter, the operations similar to those at and after time t22 already described are executed.

Then, description will be given on the processing procedure for implementing the operation shown in Fig. 16.

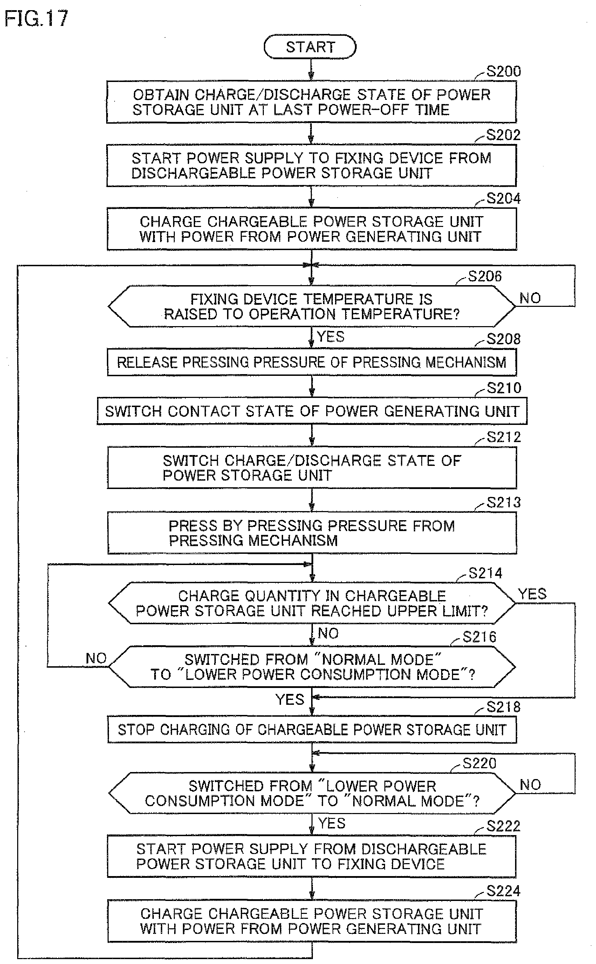

Fig. 17 is a flowchart showing the processing procedure according to the application example 2 of the embodiment of the invention. Each step shown in Fig. 17 is typically executed by control unit 114 of control module 110 after the power-on of image forming apparatus MFP.

Referring to Fig. 17, control unit 114 obtains the charge/discharge state that the power storage unit attained at the time of the last power-off (step S200). In a subsequent step S202, control unit 114 starts the power supplying (rapid discharging) to fixing device 7 from the dischargeable power storage unit. In parallel with this, control unit 114 forms a circuit in a step S204 so that the chargeable power storage unit may be charged with the power generated by power generating unit 140. Thereafter, the process proceeds to a step S206.

In step S206, control unit 114 determines whether the fixing device temperature is raised to the operation temperature or not. When the fixing device temperature is not raised to the operation temperature (NO in step S206), the processing in step S206 repeated. Conversely, when the fixing device temperature is raised to the operation temperature (YES in step S206), control unit 114 executes the switching operation in steps S208 - S212 described below.

In a step S208, control unit 114 provides an instruction to pressing mechanism 130 to release the pressing pressure applied from pressing mechanism 130. In a subsequent step S210, control unit 114 provides an instruction to switching mechanism 160 to change the contact state of power generating unit 140 by switching mechanism 160. In a subsequent step S212, control unit 114 provides an instruction to power supply unit 112 to change the charge/discharge state of the power storage unit by power supply unit 112. In a subsequent step S213, control unit 114 provides an instruction to pressing mechanism 130 to perform pressing by the pressing pressure applied from pressing mechanism 130 again. Then, the process proceeds to a step S214.

In step S214, control unit 114 determines whether the quantity of stored power of the chargeable power storage unit has reached an upper limit or not. When the quantity of stored power of the chargeable power storage unit has not reached the upper limit (NO in step S214), the process proceeds to a step S216. Conversely, when the quantity of stored power of the chargeable power storage unit has reached the upper limit (YES in step S214), the process proceeds to a step S218.

In step S216, control unit 114 determines whether the operation mode has changed from the "normal mode" to the "lower power consumption mode" or not. When the operation mode has changed from the "normal mode" to the "lower power consumption mode" (YES in step S216), the process proceeds to step S218. Conversely, when the operation mode has not changed from the "normal mode" to the "lower power consumption mode" (NO in step S216), the processing in and after step S214 will be repeated.

In step S218, control unit 114 stops the charging of the chargeable power storage unit. Thereafter, the process proceeds to a step S220.

In step S220, control unit 114 determines whether the operation mode has changed from the "lower power consumption mode" to the "normal mode" or not. When the operation mode has changed from the "lower power consumption mode" to the "normal mode" (YES in step S220), the process proceeds to a step S222. Conversely, when the operation mode has not changed from the "lower power consumption mode" to the "normal mode" (NO in step S220), the processing in step S220 is repeated.

In step S222, control unit 114 starts the power supplying (rapid discharging) from the dischargeable power storage unit to fixing device 7. In parallel with this, control unit 114 forms a circuit in a step S224 so that the chargeable power storage unit may be charged with the power generated by power generating unit 140. Thereafter, the processing in and after step S206 is repeated.

### <G. Modification>

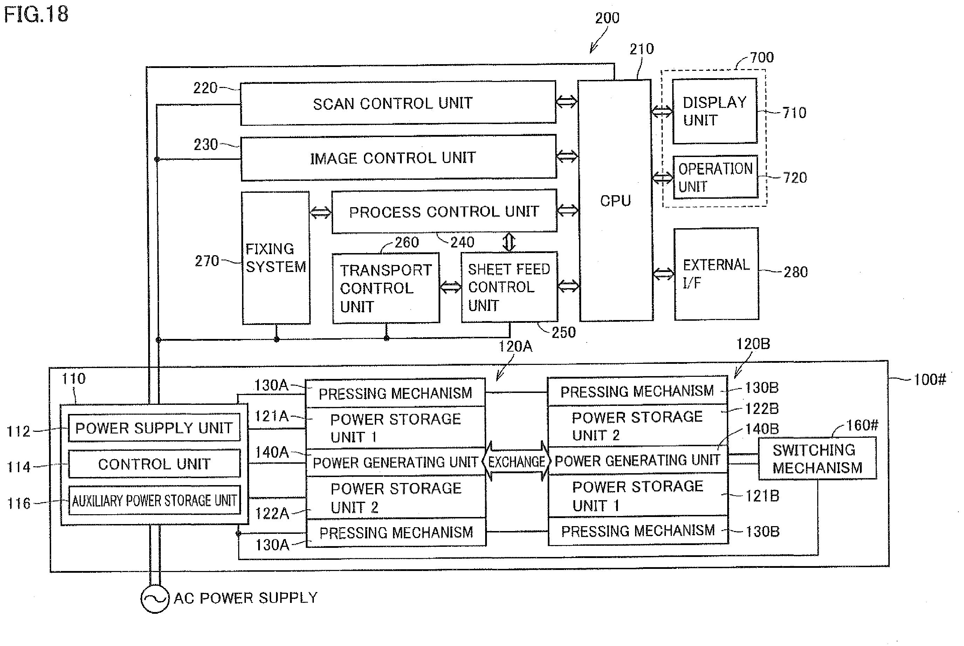

Power supply system 100 according to the embodiment already described has been exemplified in connection with the structure including one power storage module 120. From the viewpoint of simplifying the switching mechanism for switching the contact state of power generating unit 140, such a structure may be employed that at least one pair of power storage modules 120 are arranged symmetrically with each other. Referring to Fig. 18, description will be given on a power supply system 100# including such a pair of power storage modules 120.

Basically, power supply system 100# shown in Fig. 18 has substantially the same structure as power supply system 100 shown in Fig. 2 except for that it includes two power storage modules 120A and 120B arranged symmetrically with each other. Main control unit 200 shown in Fig. 18 is substantially the same as main control unit 200 shown in Fig. 2, and therefore description thereof is not repeated.

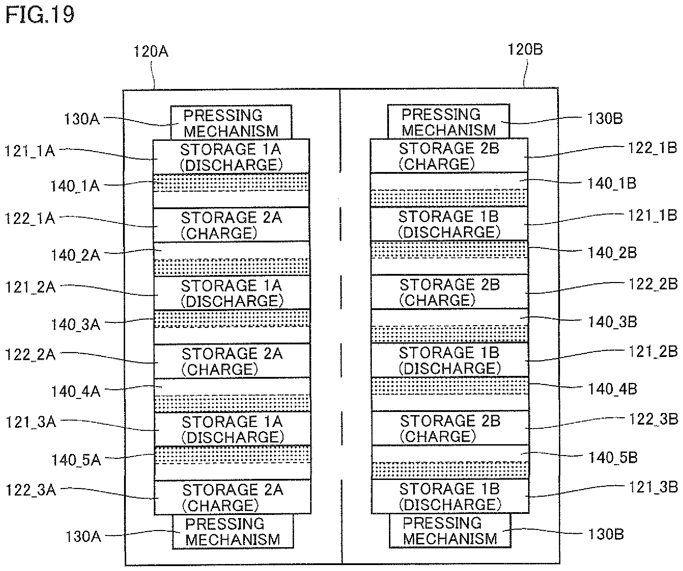

Referring to Figs. 19 to 23, the following description will be primarily given on differences with respect to power supply system 100 according to the foregoing embodiment.

### (g1. Arrangement of Power Storage Units and Power Generating Units)

Each of power storage modules 120A and 120B according to this embodiment can implement an intended function provided that it includes at least one pair of power storage units 121 and 122 as well as one power generating unit 140, but preferably employs a plurality of power generating units 140 when single power generating unit 140 cannot provide a sufficiently high terminal voltage, Accordingly, as shown in Figs. 19 to 23, it is practical to employ the plurality of power storage units and to interpose power generating unit 140 between the power storage units neighboring to each other.

For example, power storage module 120A according to the embodiment includes three power storage units 121_1A, 121_2A and 121_3A in the first group (which may be generally referred to as "power storage units 121A in the first group" hereinafter), three power storage units 122_1A, 122_2A and 122_3A in the second group (which may be generally referred to as "power storage units 122A in the second group" hereinafter), and five power generating units 140_1A, 140_2A, ···, 140_5A (which may be generally referred to as "power generating units 140A" hereinafter). For the sake of understanding, power storage unit 121A in the first group is illustrated as "POWER STORAGE UNIT 1A", and power storage unit 122A in the second group is illustrated as "POWER STORAGE UNIT 2A" in the figures.

Power storage module 120B according to the embodiment includes three power storage units 121_1B, 121_2B and 121_3B in the first group (which may be generally referred to as "power storage units 121B in the first group" hereinafter), three power storage units 122_1B, 122_2B and 122_3B in the second group (which may be generally referred to as "power storage units 122B in the second group" hereinafter), and five power generating units 140_1B, 140_2B, ···, 140_5B (which may be generally referred to as "power generating units 140B" hereinafter), For the sake of understanding, power storage unit 121B in the first group is illustrated as "POWER STORAGE UNIT 1B", and power storage unit 122B in the second group is illustrated as "POWER STORAGE UNIT 2B" in the figures.

Fig. 19 exemplifies one example for the sake of illustration, but the numbers of the power storage units included in each power storage module and others can be arbitrarily changed depending on the required design value and situation.

Power storage units 121A and 121B in the first group and power storage units 122A and 122B in the second group complementarily perform the charging operation and the discharging operation. Thus, when each of power storage units 121A and 121B in the first group is chargeable, each of power storage units 122A and 122B in the second group is dischargeable. Conversely, when each of power storage units 121A and 121B in the first group is dischargeable, each of power storage units 122A and 122B in the second group is chargeable.

In power storage module 120A, power storage units 121A in the first group are arranged alternately, in the longitudinal direction in the figure, with respect to power storage units 122A in the second group. Each of power generating units 140A is arranged between power storage unit 121A in the first group and power storage unit 122A in the second group. Further, pressing mechanisms 130A that can apply the pressure in the longitudinal direction in the figure are arranged outside power storage units 121A and 122A in the first and second groups and the plurality of power generating units 140A.

In power storage module 120B, power storage units 121B in the first group and power storage units 122B in the second group are arranged alternately to each other in the longitudinal direction in the figure, but are positioned in the order opposite to that of the power storage units in power storage unit 120A. Each power generating unit 140B is arranged between neighboring power storage unit 121B in the first group and neighboring power storage unit 122B in the second group. Further, pressing mechanisms 130B that can apply the pressure in the longitudinal direction in the figure are arranged outside power storage units 121B and 122B in the first and second groups as well as the plurality of power generating units 140B.

Figs. 19 to 23 show the structure in which pressing mechanisms 130 are arranged on the opposite sides, respectively. However, one of the end surfaces may be fixed, and the pressure may be applied by pressing mechanism 130A or 130B arranged on only the other side.

### (g2. Charge and Discharge Operations and Power Generating Operation)

Fig. 19 shows an example of a steady state of power storage module 120 according to the embodiment. Fig. 19 shows a case in which power storage units 121A and 121B in the first group are dischargeable, and power storage units 122A and 122B are chargeable.

In this steady state, when power storage units 121A and 121B in the first group are discharged, the heat generating reaction raises the temperature of power storage units 121A and 121B in the first group. When power storage units 122A and 122B in the second group are charged, the heat absorbing reaction lowers the temperature of power storage units 122A and 122B.

Consequently, each of power generating units 140A and 140B is configured such that corresponding power storage unit 121A or 121B in the first group is positioned on the side neighbor to higher-temperature-side heat transfer plate 141, and power storage unit 122A or 122B in the second group is positioned on the side neighbor to lower-temperature-side heat transfer plate 142. Consequently, the arrangement of the power storage units and the power generating units in power storage module 120A are symmetrical to those in power storage module 120B.

In Figs. 19 to 23, the side on which each higher-temperature-side heat transfer plate 141 is located in each power generating unit 140A or 140B is hatched for the sake of understanding.

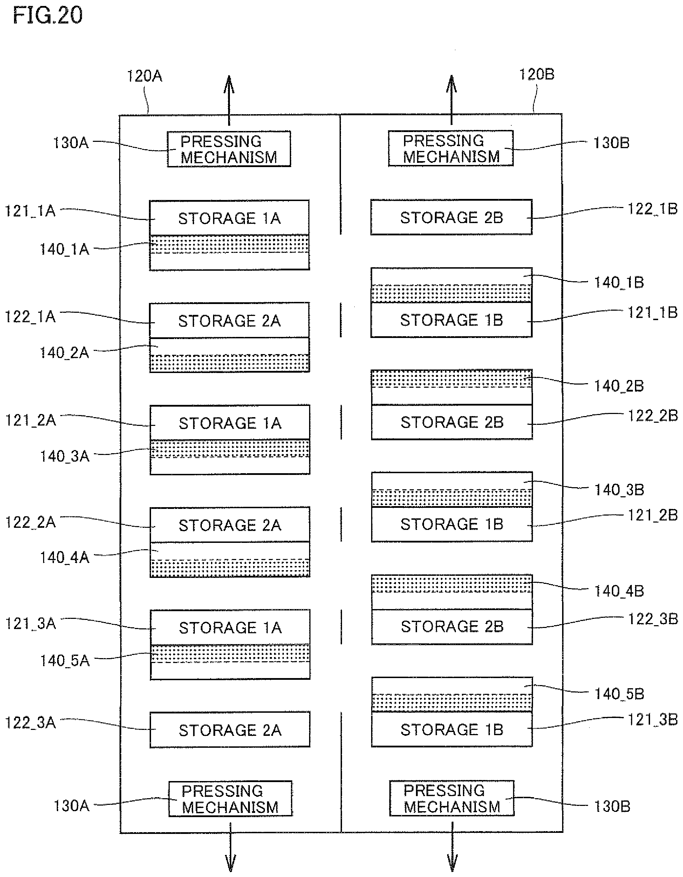

In the state shown in Fig. 19, when conditions about the remaining power quantities of power storage units 121A and 121B in the first group and/or power storage units 122A and 122B in the second group or other conditions are satisfied, the charge/discharge state is switched. In this switching operation, as shown in Fig. 20, pressing mechanisms 130A and 130B first release the pressures applied to power storage units 121A and 122A, power storage units 121B and 122B, and power generating units 140A and 140B, respectively. Thereby, power generating units 140A and 140B are released from power storage units 121A and 121B in the first group and power storage units 122A and 122B in the second group, respectively.

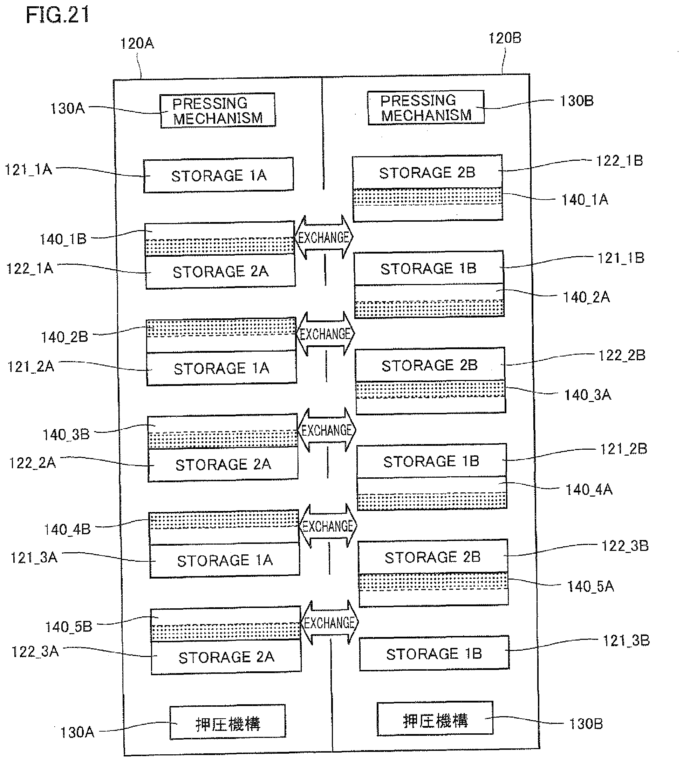

Subsequently, as shown in Fig. 21, a switching mechanism 160# (not shown therein) slides power generating unit 140A rightward in the figure, and slides power generating unit 140B leftward in the figure. Thus, switching mechanism 160# replaces power generating units 140A and 140B included in respective power storage modules 120A and 120B with each other. In this operation, it is not necessary to invert the directions of power generating units 140A and 140B.

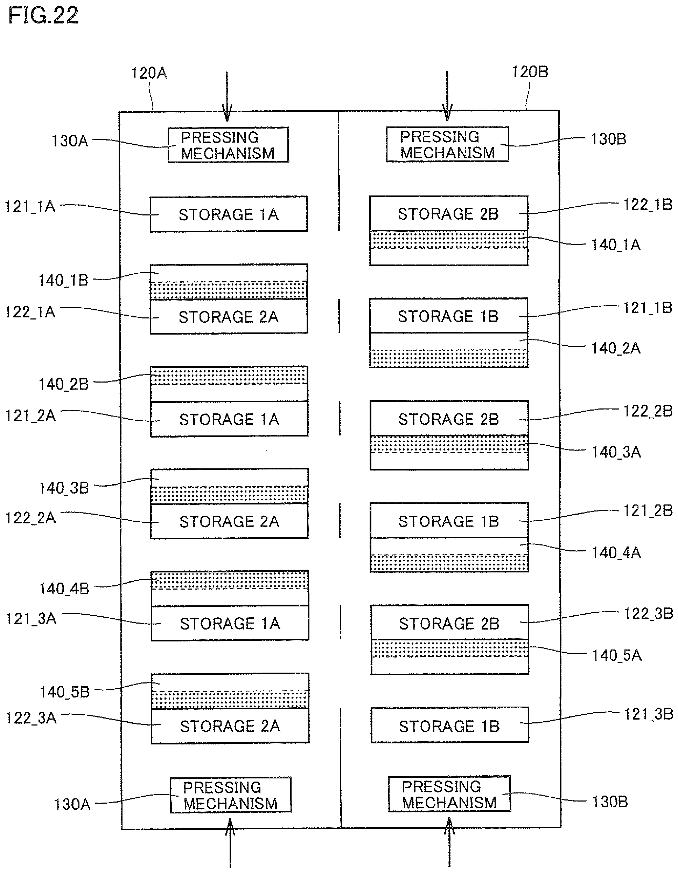

Thereafter, as shown in Fig. 22, pressing mechanism 130A applies the pressure again to power storage units 121A and 122A in the first and second groups as well as the plurality of power generating units 140B. Simultaneously, pressing mechanism 130B applies the pressure again to power storage units 121B and 122B in the first and second groups as well as the plurality of power generating units 140A.

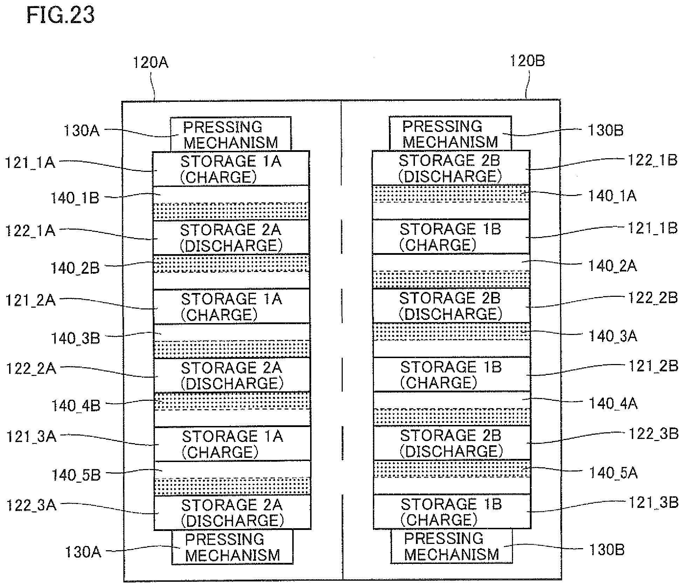

As shown in Fig. 23, power storage modules 120A and 120B exchange power generating units 140A and 140B with each other, and power storage units 121 in the first group and power storage units 122 in the second group change their charge/discharge states. Thus, power storage units 121A and 121B in the first group become chargeable, and power storage units 122A and 122B in the second group become dischargeable. Consequently, in each of power generating units 140A and 140B, power storage unit 122A or 122B in the second group at a higher temperature is in contact with higher-temperature-side heat transfer plate 141, and power storage unit 121A or 121B in the first group at a lower temperature is in contact with lower-temperature-side heat transfer plate 142. Therefore, each power generating unit 140 can continue generation of the thermal electromotive force.

During the operation of replacing power generating units 140, the state in which power storage units 121A and 121B in the first group are electrically isolated from power storage units 122A and 122B in the second group may continue. In this case, auxiliary power storage unit 116 of control module 110 supplies a required power.

In power supply system 100# according to the modification, as described above, power storage modules 120A and 120B are spaced in the lateral direction in the figure from each other by a predetermined distance. In power storage module 120A, power storage units 121A and 122A in the first and second groups are aligned in the longitudinal direction perpendicular to the lateral direction in the figure. In power storage module 120B, power storage units 121B and 122B in the first and second groups are aligned in the longitudinal direction in the figure and are arranged in the arrangement order opposite to that in power storage module 120A. Switching mechanism 160# moves power generating unit 140A in the lateral direction in the figure, and moves power generating unit 140B oppositely to power generating unit 140A in the lateral direction in the figure.

Thus, switching mechanism 160# in power supply system 100# according to the modification performs the switching between the two contact states (i.e., first and second contact states) for power generating unit 140A included in power storage module 120A and power generating unit 140B included in power storage module 120B, as described above.

More specifically, in the first contact state (see Figs. 19 and 20), power generating unit 140A in power storage module 120A has higher-temperature-side heat transfer plate 141 in contact with power storage unit 121A in the first group, and has lower-temperature-side heat transfer plate 142 in contact with power storage unit 122A in the second group. Also, power generating unit 140B in power storage module 120B has higher-temperature-side heat transfer plate 141 in contact with power storage unit 121B in the first group, and has lower-temperature-side heat transfer plate 142 in contact with power storage unit 122B in the second group.

Conversely, in the second contact state (see Figs. 21 - 23), power generating unit 140A in power storage module 120B has higher-temperature-side heat transfer plate 141 in contact with power storage unit 122B in the second group, and has lower-temperature-side heat transfer plate 142 in contact with power storage unit 121B in the first group. Also, power generating unit 140B in power storage module 120A has higher-temperature-side heat transfer plate 141 in contact with power storage unit 122A in the second group, and has lower-temperature-side heat transfer plate 142 in contact with power storage unit 121A in the first group.

### (g3. Switching Mechanism)

The mechanism of replacing power generating units 140A and 140B with each other as described above may take a mechanism of any form, but typically can employ the mechanism of belt drive similarly to that in Fig. 12.

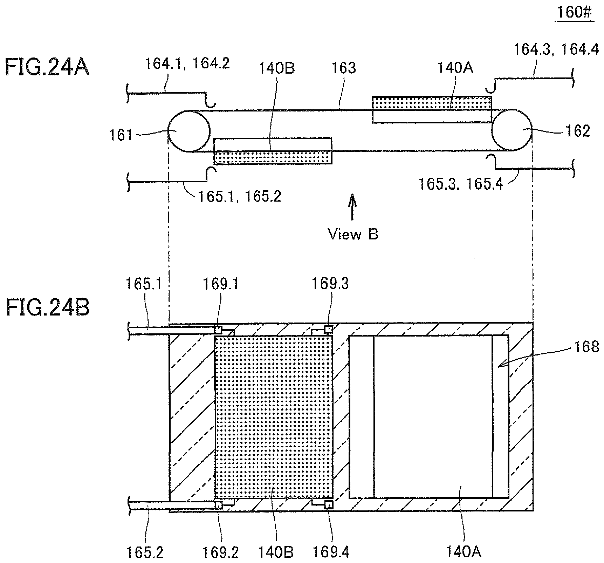

Figs. 24A and 24B show an example of switching mechanism 160# in power supply system 100# according to the modification of the embodiment of the invention. Referring to Figs. 24A and 24B, switching mechanism 160# includes circulation belt 163 arranged between rotation rollers 161 and 162. Sheet-like power generating units 140A and 140B are formed on circulation belt 163. Power generating units 140A and 140B can be replaced with each other by controlling rotation rollers 161 and 162 to rotate circulation belt 163.

In switching mechanism 160#, circulation belt 163 is partially provided with recesses 168 so that each of power generating units 140A and 140B arranged in the contact state can be directly in contact with the neighboring power storage unit. Thereby, power generating units 140A and 140B can be directly in contact with the power storage units so that the property of heat transfer between them can be improved.

On circulation belt 163, there are formed a terminal electrode (not shown) connected to a positive output terminal of power generating unit 140A, a terminal electrode (not shown) connected a negative output terminal of power generating unit 140A, terminal electrodes 169.1 and 169.3 connected to a positive output terminal of power generating unit 140B and terminal electrodes 169.2 and 169.4 connected to a negative output terminal of power generating unit 140A

Further, connector terminals 164.1, 164.2, 164.3, 164.5, 165.1, 165.2, 165.3 and 165.4 are arranged on axes of movement of these terminal electrodes. In the normal state, these connector terminals are held in positions spaced from circulation belt 163 by predetermined distances. When pressing mechanism 130A or 130B applies the pressure to power storage units 121A, 121B, 122A and 122B, the corresponding connector terminals come into electrical contact with the terminal electrodes to form a circuit for taking out the power generated by power generating units 140A and 140B.

### <H. Advantage>

The power supply system according to the embodiment has the power storage module including at least one pair of power storage units. In this power storage module, one of the power storage units becomes dischargeable, and the other becomes chargeable. The power generating unit formed of the thermoelectric converting element is arranged between these paired power storage units and is in contact with them. Therefore, when electric transfer (charging or discharging) occurs in at least one of the power storage units, the power generating unit utilizes the thermal reaction caused by such electric transfer and thereby generates the power.

Therefore, the generated thermal energy can be collected as the electric energy in either of the mode in which the power storage module performs, as a whole, the discharging operation according to the situation and/or demand of the load and the mode in which it performs the charging operation. Thereby, it is possible to improve the efficiency of use of the power.

At least one pair of the power storage modules are arranged symmetrically to each other in the power supply system according to the modification of the embodiment. Owing to the employment of this structure, the power generating units can be exchanged between these power storage modules according to the states of the respective power storage modules. Therefore, the thermal energy that occurs when the power storage modules (the respective power storage units forming them) are charged or discharged can be efficiently collected, and the mechanism for exchanging the power generating units in response to the switching of the charge/discharge states of the power storage units can be implemented by the further simplified structures.

In the application example 1 of the power supply system of the embodiment, the electric energy stored in the power storage units can be rapidly discharged, and thereby the temperature of the fixing system can be raised within a short time so that the time required for returning from the lower consumption mode can be reduced. At the same time, the power supply unit that produces the power for controlling the temperature of the fixing system from the commercial power supply is not required to cover the power that is required for the returning from the lower power consumption mode. Therefore, the power supply capacity thereof can be optimized to fall within a range required for the normal temperature control.

Further, in the application example 2 of the power supply system of the embodiment, the power supply system supplies the required power when the system is in the lower power consumption mode, and therefore can stop the power supply unit that is operable to supply the power required from the operation from the ordinary commercial power supply. This stop of the power supply unit can implement the lower power consumption and low noises.

Although the present invention has been described and illustrated in detail, it is clearly understood that the same is by way of illustration and example only and is not to be taken by way of limitation, the scope of the present invention being interpreted by the terms of the appended claims.

## Claims

1. A power supply system (100) arranged between an external power supply and a load, comprising:
**a)** a power storage module (120) including
**a1)** first and second power storage units (121, 122) arranged with a predetermined space therebetween, and
**a2)** a power generating unit (140) being capable of making a surface¹ contact² with both of said first and second power storage units (121, 122) concurrently, and formed of a thermoelectric converting element (140), said surface contact allowing the transfer of thermal energy³; and
**b)** a control unit (110, 114) for controlling charging and discharging of said first and second power storage units (121, 122), wherein
**c)** in said first and second power storage units (121, 122), different thermal reactions occur depending on whether a charging operation or a discharging operation is performed, the thermal reactions being a heat absorbing reaction and a heat generating reaction, and
**d)** said control unit (110, 114) renders one of said first and second power storage units (121, 122) dischargeable and renders the other power storage unit (122, 121) chargeable.

2. The power supply system (100) according to claim 1, further comprising:
a switching mechanism (160) for performing, in said power storage module (120), switching between a first contact state in which first and second portions (143, 142) of said power generating unit (140)⁴ are in surface contact with said first and second power storage units (121, 122), respectively, and a second state in which said second and first portions (142, 141) of said power generating unit (140) are in surface contact with said first and second power storage units (121, 122), respectively.

3. The power supply system (100), according to claim 2, wherein
said control unit (110, 114) is configured to switch, according to a predetermined condition, a state between a first charge/discharge state rendering said first power storage unit (121)
¹Para. [0069]
⁴ Para. [0069] dischargeable and rendering said second power storage unit (122) chargeable, and a second charge/discharge state rendering said first power storage unit (121) chargeable and rendering said second power storage unit (122) dischargeable, and
said switching mechanism (160) performs the switching between said first and second contact states in response to the switching between said first and second charge/discharge states by said control unit (110, 114).

4. The power supply system (100) according to claim 1, further comprising:
a pair of said power storage modules (120A, 120B) including first and second power storage modules; and
a switching mechanism for performing switching between first and second surface contact states with regard to a first power generating unit (140A) being said power generating unit included in said first power storage module and a second power generating unit (140B) being said power generating unit included in said second power storage module, wherein
in said first surface contact state,
said first power generating unit (140A) in said first power storage module has a first portion (141) being in surface contact with said first power storage unit (121A) and a second portion (142) being in surface contact with said second power storage unit (122A), and
said second power generating unit (140B) in said second power storage module has a first portion (141) being in surface contact with said first power storage unit (12 IB) and a second portion (142) being in surface contact with said second power storage unit (122B); and
in said second surface contact state,
said first power generating unit (140A) has, in said second power storage module, a first portion (141) being in surface contact with said second power storage unit (122B) and a second portion (142) being in surface contact with said first power storage unit (122A), and
said second power generating unit (140B) has, in said first power storage module, a first portion (141) being in surface contact with said second power storage unit (122A) and a second portion (142) being in surface contact with said first power storage unit (121 A).

5. The power supply system 100) according to claim 4, wherein
said first and second power storage modules are spaced in a first direction from each other by said predetermined distance,
said first and second power storage units in said first power storage module are aligned in a second direction perpendicular to said first direction,
said first and second power storage units in said second power storage module are aligned in said second direction and are arranged in an order opposite to an arrangement order in said first power storage module, and
said switching mechanism moves said first power storage unit in said first direction, and moves said second power generating unit in said first direction and oppositely to the movement of said first power generating unit.

6. The power supply system (100) according to claim 1, wherein,
said power storage module (140) further includes a pressing mechanism (130, 13OA, 13OB) adapted to apply pressure to one or both of the contact surfaces of the first power storage unit (121), the power generating unit (140) and the second power storage unit (122)⁵ for enhancing a degree of contact between said first power storage unit (121) and said power generating unit (140) as well as a degree of contact between said second power storage unit (122) and said power generating unit (140),

7. The power supply system (100) according to claim 6 and claim 2 or 4⁶, wherein
said pressing mechanism (130, 13OA, 13OB) releases a pressure applied to said first and second power storage units (121, 122) and said power generating unit (140) when said switching mechanism switches the state between said first and second contact states.

8. The power supply system (100) according to claim 6, wherein
said first and second portions of said power generating unit (140) are a pair of opposite surfaces of said power generating unit (140), respectively,
said first and second power storage units (121, 122) are aligned to each other in a direction perpendicular to said pair of surfaces to locate said power generating unit (140) between said power storage units (121, 122), and
said pressing mechanism (130, 13OA, 13OB) applies the pressure toward at least one of said paired surfaces.

9. The power supply system (100) according to claim 8, wherein
each of said paired surfaces serving as said first and second portions (121, 122) of said power generating unit (140), respectively, has an area equal to or smaller than an area of said first or second power storage unit in contact with said surface.

10. The power supply system (100) according to claim 8, wherein
said power storage module (120) includes a plurality of said first power storage units, a nluralitv of said second power storage units and a plurality of said power generating units,
said first and second power storage units (121, 122) are arranged alternately to each other in a predetermined direction, and
each of said power generating units is arranged between said first and second power storage units neighboring to each other.

11. The power supply system (100) according to claim 1, wherein
said control unit (110, 114) charges one of said first and second power storage units, using a power generated by said power generating unit (140).

12. The power supply system (100) according to claim 1, wherein
said control unit (110, 114) includes an auxiliary power storage unit (116) for driving said control unit, and
said control unit (110, 114) charges said auxiliary power storage unit, using the power generated by said power generating unit.

13. The power supply system (100) according to claim 12, wherein
said auxiliary power storage unit includes a cell formed of at least one of an electric double layer capacitor, a lithium ion battery and a lithium ion capacitor.

14. The power supply system (100) according to claim 1, wherein
said first and second power storage units include a cell formed of one of a lithium ion capacitor and a lithium ion polymer.

15. The power supply system (100) according to claim 1, wherein
said thermoelectric converting element is a bismuth-tellurium-containing element.

## Patentansprüche

1. Stromversorgungssystem (100), das zwischen einer externen Stromversorgung und einer Last angeordnet ist, umfassend:
(a) ein Stromspeichermodul (120), einschließlich:
a1) erste und zweite Stromspeichereinheiten (121, 122), die mit einem vorbestimmten Abstand dazwischen angeordnet sind, und
a2) eine Stromerzeugungseinheit (140), die einen Oberflächenkontakt¹² mit sowohl der ersten als auch der zweiten Stromspeichereinheit (121, 122) gleichzeitig herstellen kann und aus einem thermoelektrischen Wandlerelement (140) gebildet ist, wobei der Oberflächenkontakt die Übertragung von Wärmeenergie³ ermöglicht; und
(b) eine Steuereinheit (110, 114) zum Steuern des Ladens und Entladens der ersten und zweiten Stromspeichereinheit (121, 122), wobei
(c) in der ersten und zweiten Stromspeichereinheit (121, 122) unterschiedliche thermische Reaktionen in Abhängigkeit davon auftreten, ob ein Ladevorgang oder ein Entladevorgang durchgeführt wird, wobei die thermischen Reaktionen eine Wärmeabsorptionsreaktion und eine Wärmeerzeugungsreaktion sind, und
(d) die Steuereinheit (110, 114) eine von erster und zweiter Stromspeichereinheit (121, 122) entladbar und die andere Stromspeichereinheit (122, 121) aufladbar macht.

2. Stromversorgungssystem (100) nach Anspruch 1, weiter umfassend:
einen Schaltmechanismus (160) zum Durchführen, in dem Stromspeichermodul (120), eines Schaltens zwischen einem ersten Kontaktzustand, in dem erste und zweite Abschnitte (143, 142) der Stromerzeugungseinheit (140)⁴ in Oberflächenkontakt mit der ersten bzw. zweiten Speichereinheit (121, 122) sind, und einem zweiten Zustand, in dem der zweite und der erste Abschnitt (142, 141) der Stromerzeugungseinheit (140) in Oberflächenkontakt mit der ersten bzw. der zweiten Stromspeichereinheit (121, 122) sind.

3. Stromversorgungssystem (100) nach Anspruch 2, wobei:
die Steuereinheit (110, 114) konfiguriert ist, um gemäß einer vorbestimmten Bedingung einen Zustand zwischen einem ersten Lade-/Entladezustand, der die erste Stromspeichereinheit (121) entladbar macht und die zweite Stromspeichereinheit (122) aufladbar macht, und einem zweiten Lade-/Entladezustand, der die erste Stromspeichereinheit (121) aufladbar macht und die zweite Stromspeichereinheit (122) entladbar macht, zu schalten und
der Schaltmechanismus (160) das Schalten zwischen dem ersten und zweiten Kontaktzustand als Reaktion auf das Schalten zwischen dem ersten und zweiten Lade-/Entladezustand durch die Steuereinheit (110, 114) durchführt.

4. Stromversorgungssystem (100) nach Anspruch 1, weiter umfassend:
ein Paar von Stromspeichermodulen (120A, 120B), das ein erstes und ein zweites Stromspeichermodul einschließt; und
einen Schaltmechanismus zum Durchführen des Schaltens zwischen einem ersten und einem zweiten Oberflächenkontaktzustand in Bezug auf eine erste Stromerzeugungseinheit (140A), bei der es sich um die Stromerzeugungseinheit handelt, die in dem ersten Stromspeichermodul eingeschlossen ist, und einer zweiten Stromerzeugungseinheit (140B), bei der es sich um die Stromerzeugungseinheit handelt, die in dem zweiten Stromspeichermodul eingeschlossen ist, wobei
in dem ersten Oberflächenkontaktzustand
die erste Stromerzeugungseinheit (140A) in dem ersten Stromspeichermodul einen ersten Abschnitt (141) aufweist, der in Oberflächenkontakt mit der ersten Stromspeichereinheit (121A) steht, und einen zweiten Abschnitt (142) in Oberflächenkontakt mit der zweiten Stromspeichereinheit (122A) steht, und
die zweite Stromerzeugungseinheit (140B) in dem zweiten Stromspeichermodul einen ersten Abschnitt (141) aufweist, der in Oberflächenkontakt mit der ersten Stromspeichereinheit (12 IB) steht, und einen zweiten Abschnitt (142), der in Oberflächenkontakt mit der zweiten Stromspeichereinheit (122B) steht; und
wobei in dem zweiten Oberflächenkontaktzustand
die erste Stromerzeugungseinheit (140A) in dem zweiten Stromspeichermodul einen ersten Abschnitt (141) aufweist, der in Oberflächenkontakt mit der zweiten Stromspeichereinheit (122B) steht, und einen zweiten Abschnitt (142), der in Oberflächenkontakt mit der ersten Stromspeichereinheit (122A) steht, und
die zweite Stromerzeugungseinheit (140B) in dem ersten Stromspeichermodul einen ersten Abschnitt (141) aufweist, der in Oberflächenkontakt mit der zweiten Stromspeichereinheit (122A) steht, und einen zweiten Abschnitt (142), der in Oberflächenkontakt mit der ersten Stromspeichereinheit (121A) steht.

5. Stromversorgungssystem (100) nach Anspruch 4, wobei
die ersten und zweiten Stromspeichermodule in einer ersten Richtung im vorbestimmten Abstand voneinander beabstandet sind,
die ersten und zweiten Stromspeichermodule im ersten Stromspeichermodul in einer zweiten Richtung ausgerichtet sind, die senkrecht zur ersten Richtung ist,
die ersten und zweiten Stromspeichermodule im zweiten Stromspeichermodul in der zweiten Richtung ausgerichtet sind und in einer Reihenfolge, die einer Anordnungsreihenfolge im ersten Stromspeichermoduls entgegengesetzt ist, angeordnet sind, und
der Schaltmechanismus die erste Stromspeichereinheit in die erste Richtung bewegt und die zweite Stromerzeugungseinheit in die erste Richtung und entgegengesetzt der Bewegung der ersten Stromerzeugungseinheit bewegt.

6. Stromversorgungssystem (100) nach Anspruch 1, wobei
das Stromspeichermodul (140) weiter einen Druckmechanismus (130, 130A, 130B) einschließt, der zum Anlegen von Druck an eine oder beide Kontaktoberflächen der ersten Stromspeichereinheit (121), Stromerzeugungseinheit (140) und der zweiten Stromspeichereinheit (122)⁵ ausgelegt ist, um einen Kontaktgrad zwischen der ersten Stromspeichereinheit (121) und der zweiten Stromerzeugungseinheit (140) sowie einen Kontaktgrad zwischen der zweiten Stromspeichereinheit (122) und der Stromerzeugungseinheit (140) zu verbessern.

7. Stromversorgungssystem (100) nach Anspruch 6 und Anspruch 2 oder 4⁶, wobei der Druckmechanismus (130, 130A, 130B) einen Druck, der auf die erste und zweite Stromspeichereinheit (121, 122) und die Stromerzeugungseinheit (140) ausgeübt wird, lösen, wenn der Schaltmechanismus den Zustand zwischen dem ersten und zweiten Kontaktzustand schaltet.

8. Stromversorgungssystem (100) nach Anspruch 6, wobei
der erste und der zweite Abschnitt der Stromerzeugungseinheit (140) jeweils ein Paar von gegenüberliegenden Oberflächen der Stromerzeugungseinheit (140) ist,
die erste und die zweite Stromspeichereinheit (121, 122) miteinander in einer Richtung ausgerichtet sind, die senkrecht zu dem Paar von Oberflächen ist, damit sich die Stromerzeugungseinheit (140) zwischen den Stromspeichereinheiten (121, 122) befindet, und
der Druckmechanismus (130, 130A, 130B) den Druck in Richtung mindestens einer der gepaarten Oberflächen ausübt.

9. Stromversorgungssystem (100) nach Anspruch 8, wobei
jede der gepaarten Oberflächen, die als der erste und zweite Abschnitt (121, 122) der Stromerzeugungseinheit (140) dienen, jeweils einen Bereich aufweisen, der gleich oder kleiner ist als ein Bereich der ersten und zweiten Stromspeichereinheit in Kontakt mit der Oberfläche.

10. Stromversorgungssystem (100) nach Anspruch 8, wobei
das Stromspeichermodul (120) eine Vielzahl von ersten Stromspeichereinheiten, eine Vielzahl von zweiten Stromspeichereinheiten und eine Vielzahl von Stromerzeugungseinheiten einschließt,
wobei die erste und die zweite Stromspeichereinheit (121, 122) abwechselnd zueinander in einer vorbestimmten Richtung angeordnet sind, und
jede der Stromerzeugungseinheiten zwischen der ersten und zweiten Stromspeichereinheit angeordnet ist, die zueinander benachbart sind.

11. Stromversorgungssystem (100) nach Anspruch 1, wobei
die Steuereinheit (110, 114) eine von erster und zweiter Stromspeichereinheit auflädt, indem sie Strom, der durch die Stromspeichereinheit (140) erzeugt wird, verwendet.

12. Stromversorgungssystem (100) nach Anspruch 1, wobei
die Steuereinheit (110, 114) eine Hilfsstromspeichereinheit (116) zum Antreiben der Steuereinheit einschließt, und
die Steuereinheit (110, 114) die Hilfsstromspeichereinheit auflädt, indem sie Strom, der durch die Stromspeichereinheit erzeugt wird, verwendet.

13. Stromversorgungssystem (100) nach Anspruch 12, wobei
die Hilfsstromspeichereinheit eine Zelle einschließt, die mindestens aus einem elektrischen Doppelschichtkondensator, einer Lithiumionenbatterie und einem Lithiumionenkondensator gebildet ist.

14. Stromversorgungssystem (100) nach Anspruch 1, wobei
die erste und die zweite Stromspeichereinheit eine Zelle einschließen, die einem aus einem Lithiumionenkondensator und einem Lithiumionenpolymer gebildet ist.

15. Stromversorgungssystem (100) nach Anspruch 1, wobei
das thermoelektrische Wandlerelement ein Wismut-Tellur-haltiges Element ist.

## Revendications

1. Système d'alimentation électrique (100) agencé entre une alimentation électrique externe et une charge, comprenant :
a) un module de stockage d'énergie (120) incluant
a1) des première et seconde unités de stockage d'énergie (121, 122) agencées avec un espace prédéterminé entre elles et
a2) une unité génératrice d'énergie (140) capable d'effectuer un contact de surface avec l'une et l'autre desdites première et seconde unités de stockage d'énergie (121, 122) simultanément et formée d'un élément convertisseur thermoélectrique (140), ledit contact de surface permettant le transfert d'énergie thermique ; et
b) une unité de commande (110, 114) pour commander le chargement et le déchargement desdites première et seconde unités de stockage d'énergie (121, 122), dans lequel
c) dans lesdites première et seconde unités de stockage d'énergie (121, 122), différentes réactions thermiques se produisent en fonction du fait qu'une opération de chargement ou une opération de déchargement est effectuée, les réactions thermiques étant une réaction thermo-absorbante et une réaction thermo-génératrice et
d) ladite unité de commande (110, 114) rend l'une desdites première et seconde unités de stockage d'énergie (121, 122) déchargeable et rend l'autre unité de stockage d'énergie (122, 121) chargeable.

2. Système d'alimentation électrique (100) selon la revendication 1, comprenant en outre :
un mécanisme de commutation (160) pour effectuer, dans ledit module de stockage d'énergie (120), une commutation entre un premier état de contact, dans lequel une première et une seconde partie (143, 142) de ladite unité génératrice d'énergie (140)⁴ sont en contact superficiel avec lesdites première et seconde unités de stockage d'énergie (121, 122), respectivement, et un second état, dans lequel lesdites seconde et première parties (142, 141) de ladite unité génératrice d'énergie (140) sont en contact superficiel avec lesdites première et seconde unités de stockage d'énergie (121, 122), respectivement.

3. Système d'alimentation électrique (100) selon la revendication 2, dans lequel
ladite unité de commande (110, 114) est configurée pour commuter, selon une condition prédéterminée, un état entre un premier état de charge/décharge rendant ladite première unité de stockage d'énergie (121) déchargeable et rendant ladite seconde unité de stockage d'énergie (122) chargeable, et un second état de charge/décharge rendant ladite première unité de stockage d'énergie (121) chargeable et rendant ladite seconde unité de stockage d'énergie (122) déchargeable et
ledit mécanisme de commutation (160) effectue la commutation entre lesdits premier et second états de contact en réponse à la commutation entre lesdits premier et second états de charge/décharge par ladite unité de commande (110, 114).

4. Système d'alimentation électrique (100) selon la revendication 1, comprenant en outre :
une paire desdits modules de stockage d'énergie (120A, 120B) incluant un premier et un second modules de stockage d'énergie ; et
un mécanisme de commutation pour effectuer une commutation entre lesdits premier et second états de contact superficiel par rapport à une première unité génératrice d'énergie (140A), ladite unité génératrice d'énergie étant incluse dans ledit premier module de stockage d'énergie et une seconde unité génératrice d'énergie (140B), ladite unité génératrice d'énergie étant incluse dans ledit second module de stockage d'énergie, dans lequel,
dans ledit premier état de contact superficiel,
ladite première unité génératrice d'énergie (140A) dudit premier module de stockage d'énergie a une première partie (141) qui est en contact superficiel avec ladite première unité de stockage d'énergie (121A) et une seconde partie (142) qui est en contact superficiel avec ladite seconde unité de stockage d'énergie (122A), et
ladite seconde unité génératrice d'énergie (140B) dudit second module de stockage d'énergie a une première partie (141) qui est en contact superficiel avec ladite première unité de stockage d'énergie (12 IB) et une seconde partie (142) qui est en contact superficiel avec ladite seconde unité de stockage d'énergie (122B) ; et,
dans ledit second état de contact superficiel,
ladite première unité génératrice d'énergie (140A) a, dans ledit second module de stockage d'énergie, une première partie (141) qui est en contact superficiel avec ladite seconde unité de stockage d'énergie (122B) et une seconde partie (142) qui est en contact superficiel avec ladite première unité de stockage d'énergie (122A) et
ladite seconde unité génératrice d'énergie (140B) a, dans ledit premier module de stockage d'énergie, une première partie (141) qui est en contact superficiel avec ladite seconde unité de stockage d'énergie (122A) et une seconde partie (142) qui est en contact superficiel avec ladite première unité de stockage d'énergie (121A).

5. Système d'alimentation électrique (100) selon la revendication 4, dans lequel
lesdits premier et second modules de stockage d'énergie sont espacés dans une première direction l'un de l'autre par ladite distance prédéterminée,
lesdites première et seconde unités de stockage d'énergie dans ledit premier module de stockage d'énergie sont alignées dans une seconde direction perpendiculaire à ladite première direction,
lesdites première et seconde unités de stockage d'énergie dans ledit second module de stockage d'énergie sont alignées dans la seconde direction et sont agencées dans un ordre opposé à un ordre d'agencement dans ledit premier module de stockage d'énergie, et
ledit mécanisme de commutation déplace ladite première unité de stockage d'énergie dans ladite première direction et déplace ladite seconde unité génératrice d'énergie dans ladite première direction et à l'opposé du déplacement de ladite première unité génératrice d'énergie.

6. Système d'alimentation électrique (100) selon la revendication 1, dans lequel
ledit module de stockage d'énergie (140) comprend en outre un mécanisme de compression (130, 130A, 130B) qui est à même d'appliquer une pression à l'une et/ou l'autre des surfaces de contact de ladite première unité de stockage d'énergie (121), de l'unité génératrice d'énergie (140) et de la seconde unité de stockage d'énergie (122)⁵ pour renforcer un degré de contact entre ladite première unité de stockage d'énergie (121) et ladite autre unité génératrice d'énergie (140) ainsi qu'un degré de contact entre ladite seconde unité de stockage d'énergie (122) et ladite unité génératrice d'énergie (140).

7. Système d'alimentation électrique (100) selon la revendication 6 et la revendication 2 ou 4⁶, dans lequel
ledit mécanisme de compression (130, 130A, 130B) libère une pression appliquée à ladite première et à ladite seconde unité de stockage d'énergie (121, 122) et à ladite unité génératrice d'énergie (140) lorsque ledit mécanisme de commutation commute l'état entre lesdits premier et second états de contact.

8. Système d'alimentation électrique (100) selon la revendication 6, dans lequel
lesdites première et seconde parties de ladite unité génératrice d'énergie (140) constituent une paire de surfaces opposées de ladite unité génératrice d'énergie (140), respectivement,
lesdites première et seconde unités de stockage d'énergie (121, 122) sont alignées l'une avec l'autre dans une direction perpendiculaire à ladite paire de surfaces pour localiser ladite unité génératrice d'énergie (140) entre lesdites unités de stockage d'énergie (121, 122), et
ledit mécanisme de compression (130, 130A, 130B) applique la pression vers au moins l'une desdites surfaces jumelées.

9. Système d'alimentation électrique (100) selon la revendication 8, dans lequel
chacune desdites surfaces jumelées servant de dites première et secondes parties (121, 122) de ladite unité génératrice d'énergie (140), respectivement, a une surface égale ou inférieure à une surface de ladite première ou seconde unité de stockage d'énergie en contact avec ladite surface.

10. Système d'alimentation électrique (100) selon la revendication 8, dans lequel
ledit module de stockage d'énergie (120) comprend une pluralité desdites premières unités de stockage d'énergie, une pluralité desdites secondes unités de stockage d'énergie et une pluralité desdites unités génératrices d'énergie,
lesdites première et seconde unités de stockage d'énergie (121, 122) sont agencées en alternance l'une avec l'autre dans une direction prédéterminée et
chacune desdites unités génératrices d'énergie est agencée entre lesdites première et seconde unités de stockage d'énergie voisines l'une de l'autre.

11. Système d'alimentation électrique (100) selon la revendication 1, dans lequel
ladite unité de commande (110, 114) charge l'une desdites première et seconde unités de stockage d'énergie en utilisant une puissance générée par ladite unité génératrice d'énergie (140).

12. Système d'alimentation électrique (100) selon la revendication 1, dans lequel
ladite unité de commande (110, 114) comprend une unité de stockage d'énergie auxiliaire (116) pour entraîner ladite unité de commande et
ladite unité de commande (110, 114) charge ladite unité de stockage d'énergie auxiliaire en utilisant l'énergie générée par ladite unité génératrice d'énergie.

13. Système d'alimentation électrique (100) selon la revendication 12, dans lequel
ladite unité de stockage d'énergie auxiliaire comprend une cellule formée d'au moins l'un(e) d'un condensateur électrique à double couche, d'une batterie à ions lithium et d'un condensateur à ions lithium.

14. Système d'alimentation électrique (100) selon la revendication 1, dans lequel
lesdites première et seconde unités de stockage d'énergie comprennent une cellule formée de l'un d'un condensateur à ions lithium et d'un polymère à ions lithium.

15. Système d'alimentation électrique (100) selon la revendication 1, dans lequel
ledit élément de conversion thermoélectrique est un élément contenant du bismuth et du tellure.
